# NEUE EUROPÄISCHE PATENTSCHRIFT

(11) **EP 3 132 656 B2**
(45) Veröffentlichungstag und Bekanntmachung des Hinweises auf die Entscheidung über den Einspruch: **21.12.2022**
(45) Hinweis auf die Patenterteilung: 12.02.2020
(21) Anmeldenummer: 15710138.7
(22) Anmeldetag: 05.03.2015
(51) Int. Cl.: H05B 3/84, H05B 3/86, B32B 17/10, C23C 14/35

(54) **TRANSPARENTE SCHEIBE MIT HEIZBESCHICHTUNG**
TRANSPARENT DISC WITH THERMAL COATING
PLAQUE TRANSPARENTE AVEC REVÊTEMENT THERMIQUE

(30) Priorität: 17.04.2014 EP 14165092
(43) Veröffentlichungstag der Anmeldung: 22.02.2017
(73) Patentinhaber: SAINT-GOBAIN GLASS FRANCE, 92400 Courbevoie (FR)
(72) Erfinder: SCHULZ, Valentin, 52382 Niederzier (DE); SCHALL, Günther, 52372 Kreuzau (DE)
(74) Vertreter: Gebauer, Dieter Edmund
(86) Internationale Anmeldenummer: PCT/EP2015/054567
(87) Internationale Veröffentlichungsnummer: WO 2015/158462

(56) Entgegenhaltungen:
- EP-A1- 2 334 141
- WO-A1-2012/031907
- WO-A2-03/015473
- FR-A1- 2 592 544
- GB-A- 2 186 769
- GB-A- 2 381 179
- US-A1- 2003 116 551
- US-A1- 2004 065 651
- US-A1- 2012 103 961
- US-A1- 2012 193 341
- US-A1- 2013 213 949

## Beschreibung

Die Erfindung betrifft nach ihrer Gattung eine transparente Scheibe mit einer elektrisch beheizbaren Beschichtung nach dem Oberbegriff von Patentanspruch 1.

Außerdem betrifft die Erfindung ein Verfahren zur Herstellung einer transparenten Scheibe.

Transparente Scheiben mit einer elektrischen Heizschicht sind als solche wohl bekannt und bereits vielfach in der Patentliteratur beschrieben worden. Lediglich beispielhaft sei in diesem Zusammenhang auf die deutsche Offenlegungsschriften DE 102008018147 A1 und DE 102008029986 A1 verwiesen. In Kraftfahrzeugen werden sie häufig als Windschutzscheiben eingesetzt, da das zentrale Sichtfeld aufgrund gesetzlicher Vorgaben, mit Ausnahme von Heizdrähten, keinerlei Sichteinschränkungen aufweisen darf. Durch die von der Heizschicht erzeugte Wärme können binnen kurzer Zeit kondensierte Feuchtigkeit, Eis und Schnee entfernt werden. Meist werden solche Scheiben als Verbundscheiben hergestellt, in denen zwei Einzelscheiben durch eine thermoplastische Klebeschicht miteinander verbunden sind. Die Heizschicht kann auf eine der inneren Oberflächen der Einzelscheiben aufgebracht sein, wobei aber auch Aufbauten bekannt sind bei den sie sich auf einem Träger befindet, der zwischen den beiden Einzelscheiben angeordnet ist.

Die Heizschicht ist in der Regel mit mindestens einem Paar streifen- bzw. bandförmigen Sammelelektroden ("Busbars") elektrisch verbunden, die den Heizstrom möglichst gleichmäßig in die Beschichtung einleiten und auf breiter Front verteilen sollen. Für eine ansprechende ästhetische Erscheinung der Scheibe werden die undurchsichtigen Sammelelektroden durch opake Maskierungsstreifen verdeckt.

Allgemein kann die spezifische Heizleistung P_{spec} einer heizbaren Beschichtung durch die Formel P_{spec} = U²/(R_{□}•D²) beschrieben werden, worin U die Speisespannung, R_{□} den elektrischen Flächenwiderstand der Beschichtung und D den Abstand zwischen den beiden Sammelelektroden darstellen. Der Flächenwiderstand R_{□} der Beschichtung liegt bei den derzeit in der industriellen Serienfertigung eingesetzten Materialien in der Größenordnung von einigen Ohm pro Flächeneinheit (Ω/□).

Um mit der in Kraftfahrzeugen standardmäßig zur Verfügung stehenden Bordspannung von 12 bis 24 V eine für den gewünschten Zweck zufriedenstellende Heizleistung zu erzielen, sollten die Sammelelektroden einen möglichst geringen Abstand D voneinander haben. In Anbetracht der Tatsache, dass der Widerstand R der heizbaren Beschichtung mit der Länge des Strompfads zunimmt und da die Fahrzeugscheiben in der Regel breiter als hoch sind, sind die Sammelelektrode normalerweise entlang des oberen und unteren Scheibenrands angeordnet, so dass der Heizstrom über den kürzeren Weg der Scheibenhöhe fließen kann.

Nun schirmen Scheiben mit einer elektrischen Heizschicht elektromagnetische Strahlung relativ stark ab, so dass insbesondere in Kraftfahrzeugen mit einer heizbaren Windschutzscheibe der Funkdatenverkehr erheblich beeinträchtigt sein kann. Heizbare Windschutzscheiben werden deshalb häufig mit beschichtungsfreien Zonen ("Kommunikations- oder Sensorfenster") versehen, die zumindest für bestimmte Bereiche des elektromagnetischen Spektrums gut durchlässig sind, um auf diese Weise einen reibungslosen Datenverkehr zu ermöglichen. Die beschichtungsfreien Zonen, an denen sich häufig elektronische Einrichtungen, wie Sensoren und dergleichen befinden, sind gewöhnlich in der Nähe des oberen Scheibenrands angeordnet, wo sie vom oberen Maskierungsstreifen gut verdeckt werden können.

Jedoch beeinträchtigen beschichtungsfreie Zonen die elektrischen Eigenschaften der Heizschicht, was sich zumindest lokal auf die Stromdichteverteilung des durch die Heizschicht fließenden Heizstroms auswirkt. Tatsächlich verursachen sie eine stark inhomogene Heizleistungsverteilung, bei der die Heizleistung unterhalb und in der Umgebung der beschichtungsfreien Zonen deutlich verringert ist. Andererseits treten Stellen mit einer besonders hohen Stromdichte auf ("Hot Spots"), in denen die Heizleistung stark erhöht ist. In der Folge können sehr hohe lokale Scheibentemperaturen auftreten, die eine Gefahr für Verbrennungen darstellen und den Scheiben große thermische Spannungen auferlegen. Zudem können sich dadurch Klebstellen von Anbauteilen lösen.

Die Fachwelt hat versucht, diese Probleme durch die Formgebung des Heizfelds und/oder der Sammelleitungen und/oder den Einbau einer dritten Sammelleitung zu beheben.

So ist beispielsweise aus der britischen Patentanmeldung GB 2381179 A eine beheizbare Windschutzscheibe bekannt, deren Heizschicht in mindestens zwei Felder oder Zonen aufgeteilt ist, die durch unbeschichtete Bereiche voneinander getrennt sind. Das beschichtungsfreie Kommunikationsfenster befindet sich in der zentralen Zone der Beschichtung. Die im eingebauten Zustand obere Sammelleitung wird um drei Ränder (horizontaler unterer Rand und die zwei parallel zueinander verlaufende vertikale Seitenränder) des Kommunikationsfensters geführt. Die längs der beiden Seitenränder verlaufenden Teilstrecken der Sammelleitung werden durch die beiden unbeschichteten Bereiche, die die zentrale Zone von den beiden seitlich davon liegenden Zonen trennen, geführt.

Aus der internationalen Patentanmeldung WO 2011/006743 A1 ist eine beheizbare Windschutzscheibe bekannt, die auf einem transparenten Substrat eine elektrisch leitfähige Beschichtung, zwei elektrische Sammelbänder, mindestens einen örtlich begrenzten, von der Beschichtung abgegrenzten Bereich und innerhalb dieses Bereichs einen beschichtungsfreien Bereich als Kommunikationsfenster aufweist. Der abgegrenzte Bereich ist durch mindestens zwei parallel zu Äquipotenziallinien verlaufende, über mindestens einen ohmschen Widerstand verbundene Stromsammelbereiche auf der Beschichtung und mindestens zwei parallel zu elektrischen Feldlinien verlaufende, elektrisch isolierende Trennlinien zumindest teilweise begrenzt.

Aus der europäischen Patentanmeldung EP 2 334 141 A1 ist ebenfalls eine beschichtete Scheibe mit einem beheizbaren Kommunikationsfenster bekannt. In dem beschichtungsfreien Bereich des Kommunikationsfensters ist mindestens ein Heizleiter mit zwei Polen aufgebracht, wobei der erste Pol mit der elektrisch leitfähigen transparenten Beschichtung elektrisch verbunden ist und der zweite Pol mit der besagten Beschichtung oder einem Stromsammelband elektrisch verbunden ist.

Aus den internationalen Patentanmeldungen WO 2012/031907 A1 und WO 2012/031908 A1 ist ebenfalls eine transparente Scheibe mit einer elektrisch heizbaren Beschichtung bekannt, die mit mindestens zwei zum elektrischen Verbindungen mit den beiden Polen einer Spannungsquelle vorgesehenen ersten Elektroden elektrisch verbunden ist, so dass durch Anlegen einer Speisespannung ein Heizstrom über ein zwischen den beiden ersten Elektroden gebildetes Heizfeld fließt. Dabei weist das Heizfeld mindestens eine beschichtungsfreie Zone als Kommunikationsfenster auf, die von einem zumindest abschnittsweise von der heizbaren Beschichtung gebildeten Zonenrand begrenzt wird.

Die Scheibe weist des Weiteren eine zweite Elektrode auf, die zum Verbinden mit dem einen Pol der Spannungsquelle vorgesehen ist. Diese zweite Elektrode verfügt über wenigstens einen zumindest abschnittsweise in der beschichtungsfreien Zone angeordneten Zuleitungsabschnitt und einen oder mehrere mit dem Zuleitungsabschnitt verbundene Anschlussabschnitte. Dabei erstrecken sich die Anschlussabschnitte jeweils ausgehend von der beschichtungsfreien Zone über einen Randabschnitt des Zonenrand hinweg. Der Randabschnitt wird von einem Abschnitt des Heizfelds gebildet, der sich zwischen der beschichtungsfreien Zone und der zur Verbindung mit dem anderen Pol der Spannungsquelle vorgesehenen ersten Elektrode befindet.

In einer Ausführungsform besteht der Zuleitungsabschnitt aus mindestens zwei voneinander getrennten Zuleitungsteilen, die jeweils einen Kopplungsadapter aufweisen, der mit der heizbaren Beschichtung elektrisch verbunden ist. Dabei sind die beiden Kopplungsabschnitte so angeordnet, dass sie durch die heizbare Beschichtung galvanisch gekoppelt sind.

WO 03/015473 A2 offenbart eine transparente Scheibe gemäß dem Oberbegriff vom Anspruch 1.

Diese bekannten Konfigurationen beheizbarer Scheiben haben bereits einen beträchtlichen Fortschritt mit sich gebracht. Indes können die bekannten Konfigurationen die vorstehend geschilderten Probleme der lokalen Überhitzung nicht bei beheizbaren Scheiben zur Zufriedenheit lösen, die ein besonders großes Kommunikationsfenster und/oder ein geometrisch besonders anspruchsvolles Design der schwarzen Randbeschichtung aufweisen.

Demgegenüber besteht die Aufgabe der vorliegenden Erfindung darin, die bekannten gattungsgemäßen Scheiben so weiterzubilden, dass die Scheiben mit einer zumindest annähernd gleichmäßigen Heizleistungsverteilung beheizbar ist und keine durch neue, geometrisch besonders anspruchsvolle Designs der schwarzen Randbeschichtung und/oder durch besonders große Kommunikationsfenster hervorgerufene Hot Spots mehr aufweisen. Diese und weitere Aufgaben werden nach dem Vorschlag der Erfindung durch eine transparente Scheibe mit den Merkmalen des unabhängigen Patentanspruchs gelöst. Vorteilhafte Ausgestaltungen der Erfindung sind durch die Merkmale der Unteransprüche angegeben.

In einer vorteilhaften Ausgestaltung der erfindungsgemäßen Scheibe ist die Oberfläche der ersten Scheibe, auf der die elektrisch beheizbare Beschichtung angeordnet ist, über eine thermoplastische Zwischenschicht mit einer zweiten Scheibe flächig verbunden ist

Als erste und gegebenenfalls zweite Scheibe sind im Grunde alle elektrisch isolierenden Substrate geeignet, die unter den Bedingungen der Herstellung und der Verwendung der erfindungsgemäßen Scheibe thermisch und chemisch stabil sowie dimensionsstabil sind.

Die erste Scheibe und/oder die zweite Scheibe enthalten bevorzugt Glas, besonders bevorzugt Flachglas, Floatglas, Quarzglas, Borosilikatglas, Kalk-Natron-Glas, oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon. Die erste Scheibe und/oder die zweite Scheibe sind bevorzugt transparent, insbesondere für die Verwendung der Scheibe als Windschutzscheibe oder Rückscheibe eines Fahrzeugs oder anderen Verwendungen bei denen eine hohe Lichttransmission erwünscht ist. Als transparent im Sinne der Erfindung wird dann eine Scheibe verstanden, die eine Transmission im sichtbaren Spektralbereich >70 % aufweist. Für Scheiben, die nicht im verkehrsrelevanten Sichtfeld des Fahrers liegen, beispielsweise für Dachscheiben, kann die Transmission aber auch viel geringer sein, beispielsweise >5 %.

Die Dicke der erfindungsgemäßen Scheibe kann breit variieren und so hervorragend den Erfordernissen des Einzelfalls angepasst werden. Vorzugsweise werden Scheiben mit den Standardstärken von 1,0 mm bis 25 mm, bevorzugt von 1,4 mm bis 2,5 mm für Fahrzeugglas und bevorzugt von 4 mm bis 25 mm für Möbel, Geräte und Gebäude, insbesondere für elektrische Heizkörper, verwendet. Die Größe der Scheibe kann breit variieren und richtet sich nach der Größe der erfindungsgemäßen Verwendung. Die erste Scheibe und gegebenenfalls die zweite Scheibe weisen beispielsweise im Fahrzeugbau und Architekturbereich übliche Flächen von 200 cm² bis zu 20 m² auf.

Die erfindungsgemäße Scheibe kann eine beliebige dreidimensionale Form aufweisen. Vorzugsweise hat die dreidimensionale Form keine Schattenzonen, so dass sie beispielsweise durch Kathodenzerstäubung beschichtet werden kann. Bevorzugt sind die Substrate planar oder leicht oder stark in einer Richtung oder in mehreren Richtungen des Raumes gebogen. Insbesondere werden planare Substrate verwendet. Die Scheiben können farblos oder gefärbt sein.

Mehrere Scheiben werden durch mindesten eine Zwischenschicht miteinander verbunden. Die Zwischenschicht enthält vorzugsweise mindestens einen thermoplastischen Kunststoff, bevorzugt Polyvinylbutyral (PVB), Ethylenvinylacetat (EVA) und/oder Polyethylenterephthalat (PET). Die thermoplastische Zwischenschicht kann aber auch beispielsweise Polyurethan (PU), Polypropylen (PP), Polyacrylat, Polyethylen (PE), Polycarbonat (PC), Polymethylmetacrylat, Polyvinylchlorid, Polyacetatharz, Gießharze, fluorierte Ethylen-Propylen-Copolymerisate, Polyvinylfluorid und/oder Ethylen-Tetrafluorethylen-Copolymerisate, oder Copolymere oder Gemische davon enthalten. Die thermoplastische Zwischenschicht kann durch eine oder auch durch mehrere übereinander angeordnete thermoplastische Folien ausgebildet werden, wobei die Dicke einer thermoplastischen Folie bevorzugt von 0,25 mm bis 1 mm beträgt, typischerweise 0,38 mm oder 0,76 mm.

Bei einer erfindungsgemäßen Verbundscheibe aus einer ersten Scheibe, einer Zwischenschicht und einer zweiten Scheibe kann die elektrisch beheizbare Beschichtung direkt auf der erste Scheibe aufgebracht sein oder auf eine Trägerfolie oder auf die Zwischenschicht selbst aufgebracht sein. Die erste Scheibe und die zweite Scheibe weisen jeweils eine innenseitige Oberfläche und eine außenseitige Oberfläche auf. Die innenseitigen Oberflächen der ersten und der zweiten Scheibe sind einander zugewandt und über die thermoplastische Zwischenschicht miteinander verbunden. Die außenseitigen Oberflächen der ersten und der zweiten Scheibe sind voneinander und von der thermoplastischen Zwischenschicht abgewandt. Die elektrisch leitfähige Beschichtung ist auf der innenseitigen Oberfläche der ersten Scheibe aufgebracht. Natürlich kann auch auf der innenseitigen Oberfläche der zweiten Scheibe eine weitere elektrisch leitfähige Beschichtung aufgebracht sein. Auch die außenseitigen Oberflächen der Scheiben können Beschichtungen aufweisen. Die Begriffe "erste Scheibe" und "zweite Scheibe" sind zur Unterscheidung der beiden Scheiben bei einer erfindungsgemäßen Verbundscheibe gewählt. Mit den Begriffen ist keine Aussage über die geometrische Anordnung verbunden. Ist die erfindungsgemäße Scheibe beispielsweise dafür vorgesehen, in einer Öffnung, beispielsweise eines Fahrzeugs oder eines Gebäudes, den Innenraum gegenüber der äußeren Umgebung abzutrennen, so kann die ersten Scheibe dem Innenraum oder der äußeren Umgebung zugewandt sein.

Die erfindungsgemäße transparente Scheibe umfasst eine elektrisch leitfähige, beheizbare, transparente Beschichtung, die sich zumindest über einen wesentlichen Teil der Scheibenfläche, insbesondere über deren Sichtfeld, erstreckt. Die elektrisch leitfähige Beschichtung ist mit mindestens zwei, insbesondere zwei, zum elektrischen Verbinden mit den beiden Polen einer Spannungsquelle vorgesehenen Sammelelektroden elektrisch so verbunden, dass durch Anlegen einer Speisespannung ein Heizstrom über ein zwischen den beiden Sammelelektroden geformtes Heizfeld fließt. Typischerweise sind die beiden Sammelelektroden jeweils in Form einer streifen- oder bandförmigen Elektrode oder Sammelschiene oder Busbar zum Einleiten und breiten Verteilen des Stroms in der leitfähige Beschichtung ausgebildet. Zu diesem Zweck sind sie mit der Heizschicht galvanisch verbunden.

Für die Alternative (i) von Patentanspruch 1 ist mindestens eine, insbesondere eine, der beiden Sammelelektroden, bevorzugt die im eingebauten Zustand der transparenten Scheibe obere Sammelelektrode, in mindestens zwei, insbesondere zwei, voneinander getrennte Teilbereiche untergliedert. Für die Alternativen (ii) und (iii) von Patentanspruch 1 ist vorzugsweise mindestens eine, insbesondere eine, der beiden Sammelelektroden, bevorzugt die im eingebauten Zustand der transparenten Scheibe obere Sammelelektrode, in mindestens zwei, insbesondere zwei, voneinander getrennte Teilbereiche untergliedert.

In einer vorteilhaften Ausgestaltung ist die Sammelektrode als aufgedruckte und eingebrannte leitfähige Struktur ausgebildet. Die aufgedruckte Sammelelektrode enthält bevorzugt zumindest ein Metall, eine Metalllegierung, eine Metallverbindung und/oder Kohlenstoff, besonders bevorzugt ein Edelmetall und insbesondere Silber. Die Druckpaste zur Herstellung der Sammelelektrode enthält bevorzugt metallische Partikel Metallpartikel und/oder Kohlenstoff und insbesondere Edelmetallpartikel wie Silberpartikel. Die elektrische Leitfähigkeit wird bevorzugt durch die elektrisch leitenden Partikel erzielt. Die Partikel können sich in einer organischen und/oder anorganischen Matrix wie Pasten oder Tinten befinden, bevorzugt als Druckpaste mit Glasfritten.

Die Schichtdicke der aufgedruckten Sammelelektrode beträgt bevorzugt von 5 µm bis 40 µm, besonders bevorzugt von 8 µm bis 20 µm und ganz besonders bevorzugt von 8 µm bis 12 µm. Aufgedruckte Sammelelektroden mit diesen Dicken sind technisch einfach zu realisieren und weisen eine vorteilhafte Stromtragfähigkeit auf.

Der spezifische Widerstand ρₐ der Sammelelektrode beträgt bevorzugt von 0.8 µOhm•cm bis 7.0 µOhm•cm und besonders bevorzugt von 1.0 µOhm•cm bis 2.5 µOhm•cm. Sammelelektroden mit spezifischen Widerständen in diesem Bereich sind technisch einfach zu realisieren und weisen eine vorteilhafte Stromtragfähigkeit auf.

Alternativ kann die Sammelelektrode aber auch als ein Streifen oder im Falle einer in Teilbereiche untergliederten Sammelelektrode als mindestens zwei, insbesondere zwei, Streifen einer elektrisch leitfähigen Folie ausgebildet sein. Die Sammelelektrode enthält dann beispielsweise zumindest Aluminium, Kupfer, verzinntes Kupfer, Gold, Silber, Zink, Wolfram und/oder Zinn oder Legierungen davon. Der Streifen hat bevorzugt eine Dicke von 10 µm bis 500 µm, besonders bevorzugt von 30 µm bis 300 µm. Sammelelektroden aus elektrisch leitfähigen Folien mit diesen Dicken sind technisch einfach zu realisieren und weisen eine vorteilhafte Stromtragfähigkeit auf. Der Streifen kann mit der elektrisch leitfähigen Struktur beispielsweise über eine Lötmasse, über einen elektrisch leitfähigen Kleber oder durch direktes Auflegen elektrisch leitend verbunden sein.

Die elektrisch leitfähige Beschichtung der erfindungsgemäßen Scheibe lässt sich in ein Heizfeld, d.h. den beheizbaren Teil der elektrisch leitfähigen Beschichtung, der sich zwischen den beiden Sammelelektroden befindet, so dass ein Heizstrom eingeleitet werden kann, und einen Bereich außerhalb des erwähnten Heizfelds unterteilen.

Elektrisch beheizbare Beschichtungen sind beispielsweise aus DE 20 2008 017 611 U1, EP 0 847 965 B1 oder WO2012/052315 A1 bekannt. Sie enthalten typischerweise eine funktionelle Schicht oder mehrere, beispielsweise zwei, drei oder vier elektrisch leitfähige, funktionelle Schichten. Die funktionellen Schichten enthalten bevorzugt zumindest ein Metall, beispielsweise Silber, Gold, Kupfer, Nickel und oder Chrom, oder eine Metalllegierung. Die funktionellen Schichten enthalten besonders bevorzugt mindestens 90 Gew.-% des Metalls, insbesondere mindestens 99,9 Gew.-% des Metalls. Die funktionellen Schichten können aus dem Metall oder der Metalllegierung bestehen. Die funktionellen Schichten enthalten besonders bevorzugt Silber oder eine silberhaltige Legierung. Solche funktionelle Schichten weisen eine besonders vorteilhafte elektrische Leitfähigkeit bei gleichzeitiger hoher Transmission im sichtbaren Spektralbereich auf. Die Dicke einer funktionellen Schicht beträgt bevorzugt von 5 nm bis 50 nm, besonders bevorzugt von 8 nm bis 25 nm. In diesem Bereich für die Dicke der funktionellen Schicht wird eine vorteilhaft hohe Transmission im sichtbaren Spektralbereich und eine besonders vorteilhafte elektrische Leitfähigkeit erreicht.

Typischerweise ist jeweils zwischen zwei benachbarten funktionellen Schichten der elektrisch leitfähigen Beschichtung zumindest eine dielektrische Schicht angeordnet. Bevorzugt ist unterhalb der ersten und/oder oberhalb der letzten funktionellen Schicht eine weitere dielektrische Schicht angeordnet. Eine dielektrische Schicht enthält zumindest eine Einzelschicht aus einem dielektrischen Material, beispielsweise ein Nitrid wie Siliziumnitrid oder ein Oxid wie Aluminiumoxid. Die dielektrische Schicht kann aber auch mehrere Einzelschichten umfassen, beispielsweise Einzelschichten eines dielektrischen Materials, Glättungsschichten, Anpassungsschichten, Blockerschichten und/oder Antireflexionsschichten. Die Dicke einer dielektrischen Schicht beträgt beispielsweise von 10 nm bis 200 nm.

Dieser Schichtaufbau wird im Allgemeinen durch eine Folge von Abscheidevorgängen erhalten, die durch ein Vakuumverfahren wie die magnetfeldgestützte Kathodenzerstäubung durchgeführt werden.

Weitere geeignete elektrisch leitfähigen Beschichtungen enthalten bevorzugt Indium-Zinnoxid (ITO), fluordotiertes Zinnoxid (SnO₂:F) oder aluminiumdotiertes Zinkoxid (ZnO:Al).

Die elektrisch leitfähige Beschichtung kann prinzipiell jede Beschichtung sein, die elektrisch kontaktiert werden soll. Soll die erfindungsgemäße Scheibe die Durchsicht ermöglichen, wie es beispielsweise bei Scheiben im Fensterbereich der Fall ist, so ist die elektrisch leitfähige Beschichtung bevorzugt transparent. Die elektrisch leitfähige Beschichtung ist bevorzugt für elektromagnetische Strahlung transparent, besonders bevorzugt für elektromagnetische Strahlung einer Wellenlänge von 300 bis 1300 nm und insbesondere für sichtbares Licht.

In einer vorteilhaften Ausgestaltung ist die elektrisch leitfähige Beschichtung eine Schicht oder ein Schichtaufbau mehrerer Einzelschichten mit einer Gesamtstärke von kleiner oder gleich 2 µm, besonders bevorzugt kleiner oder gleich 1 µm.

Eine vorteilhafte elektrisch leitfähige Beschichtung weist einen Flächenwiderstand von 0,4Ω/□ bis 10 Ω/□ auf. In einer besonders bevorzugten Ausgestaltung weist die erfindungsgemäße elektrisch leitfähige Beschichtung einen Flächenwiderstand von 0,5 Ω/□ bis 1 Ω/□ auf. Beschichtungen mit derartigen Flächenwiderständen eignen sich besonders zur Beheizung von Fahrzeugscheiben bei typischen Bordspannungen von 12 V bis 48 Volt oder bei Elektrofahrzeugen mit typischen Bordspannungen von bis zu 500 V.

Die elektrisch leitfähige Beschichtung kann sich über die gesamte Oberfläche der ersten Scheibe erstrecken. Die elektrisch leitfähige Beschichtung kann sich alternativ aber auch nur über einen Teil der Oberfläche der ersten Scheibe erstrecken. Die elektrisch leitfähige Beschichtung erstreckt sich bevorzugt über mindestens 50%, besonders bevorzugt über mindestens 70% und ganz besonders bevorzugt über mindestens 90% der innenseitigen Oberfläche der ersten Scheibe.

In einer vorteilhaften Ausgestaltung einer erfindungsgemäßen transparenten Scheibe als Verbundscheibe weist die innenseitige Oberfläche der ersten Scheibe einen umlaufenden Randbereich mit einer Breite von 2 mm bis 50 mm, bevorzugt von 5 mm bis 20 mm auf, der nicht mit der elektrisch leitfähigen Beschichtung versehen ist. Die elektrisch leitfähige Beschichtung weist dann keinen Kontakt zur Atmosphäre auf und ist im Inneren der Scheibe durch die thermoplastische Zwischenschicht vorteilhaft vor Beschädigungen und Korrosion geschützt.

In der erfindungsgemäßen transparenten Scheibe enthält das Heizfeld zumindest eine beschichtungsfreie Zone, in der keine elektrisch leitfähige Beschichtung vorhanden ist. Die beschichtungsfreie Zone wird von einem zumindest abschnittsweise von der elektrisch leitfähigen Beschichtung gebildeten Zonenrand begrenzt.

Insbesondere verfügt die beschichtungsfreie Zone über einen umlaufenden Zonenrand, der vollständig von der elektrisch leitfähigen Beschichtung gebildet wird.

Indes kann der Zonenrand in den umlaufenden Beschichtungsrand der elektrisch leitfähigen Beschichtung übergehen, so dass die beschichtungsfreie Zone direkt mit dem die Scheibenränder umlaufenden, beschichtungsfreien Randstreifen der erfindungsgemäßen transparenten Scheibe verbunden ist.

Die beschichtungsfreie Zone kann die unterschiedlichsten Umrisse aufweisen. So kann der Umriss quadratisch, rechteckig, trapezförmig, dreieckig, fünfeckig, sechseckig, siebeneckig oder achteckig mit abgerundeten Ecken und/oder gebogenen Kanten sowie kreisförmig, oval, tropfenförmig oder elliptisch sein. Die Umrisslinien können einen geradlinigen, wellenförmigen, zickzackförmigen und/oder sägezahnförmigen Verlauf haben. Mehrere dieser geometrischen Merkmale können bei ein und derselben beschichtungsfreien Zone verwirklicht sein.

Insbesondere dient die beschichtungsfreie Zone als Kommunikationsfenster, das für elektromagnetische Strahlung, insbesondere IR-Strahlung, Radarstrahlung und/oder Funkstrahlung, durchlässig ist. Außerdem können in dem Kommunikationsfenster auch Sensoren, beispielsweise Regensensoren, platziert werden.

Die beschichtungsfreie Zone kann beispielsweise durch Maskierung beim Aufbringen der Heizschicht auf ein Substrat oder durch Entfernen der Heizschicht beispielsweise durch mechanischen und/oder chemischen Abtrag und/oder durch Abtrag durch Bestrahlung mit elektromagnetischer Strahlung, insbesondere Laserlichtbestrahlung, nach dem Aufbringen der elektrisch beheizbaren Beschichtung hergestellt werden.

Bei einer bevorzugten Ausführungsform ist mindestens eine, insbesondere eine beschichtungsfreie Zone vorhanden.

Vorzugsweise ist diese mindestens eine zweite beschichtungsfreie Zone im eingebauten Zustand der erfindungsgemäßen transparenten Scheibe oberhalb der mindestens einen ersten beschichtungsfreien Zone angeordnet.

Vorzugsweise weist die mindestens eine zweite beschichtungsfreie Zone die vorstehend beschriebenen Umrisse und Umrisslinien auf.

Vorzugsweise hat die mindestens eine zweite beschichtungsfreie Zone eine kleinere Fläche als die mindestens eine erste beschichtungsfreie Zone.

Es ist ein besonderer Vorteil der erfindungsgemäßen transparenten Scheibe, dass
- mindestens eine, insbesondere eine, erste beschichtungsfreie Zone und mindestens eine, insbesondere eine, zweite beschichtungsfreie Zone,
- mindestens eine, insbesondere eine, erste beschichtungsfreie Zone und mindestens eine Zone des Randstreifens,
- mindestens eine, insbesondere eine, zweite beschichtungsfreie Zone und mindestens eine Zone des Randstreifens oder
- mindestens eine, insbesondere eine, erste beschichtungsfreie Zone, mindestens eine, insbesondere eine, zweite beschichtungsfreie Zone und mindestens eine Zone des Randstreifens
mindestens eine, insbesondere eine, einheitliche beschichtungsfreie Zone bilden können.

Bevorzugt ist die mindestens eine beschichtungsfreie Zone im eingebauten Zustand der transparenten Scheibe in deren oberen Bereich angeordnet.

Nach dem Vorschlag der Erfindung zeichnet sich die erfindungsgemäße transparente Scheibe in wesentlicher Weise dadurch aus, dass sie zumindest eine, insbesondere eine, zum elektrischen Verbinden mit dem einen Pol der Spannungsquelle vorgesehene Zusatzelektrode oder dritte Busbar aufweist, die zumindest abschnittsweise, insbesondere nur mit einem Elektrodenabschnitt, in der beschichtungsfreien Zone oder bevorzugt in und/oder auf dem Heizfeld der elektrisch beheizbaren Beschichtung angeordnet und mit der elektrisch leitfähigen Beschichtung elektrisch so verbunden ist, dass bei Anlegen einer Speisespannung ein Teil des Heizstroms über einen Heizfeldabschnitt des Heizfelds fließt, der sich zwischen der Zusatzelektrode oder der beschichtungsfreien Zone und der zur Verbindung mit dem anderen Pol der Spannungsquelle vorgesehenen Sammel-elektrode befindet.

Mindestens eine der Zusatzelektroden oder die eine Zusatzelektrode kann in mindestens zwei, insbesondere zwei, voneinander getrennte Teilbereiche untergliedert sein.

Erfindungsgemäß erstreckt sich die mindestens eine Zusatzelektrode oder erstrecken sich die mindestens zwei voneinander getrennten Teilbereiche der Zusatzelektrode längs des im eingebauten Zustand der erfindungsgemäßen transparenten Scheibe unteren Zonenrands der mindestens einen beschichtungsfreien Zone. "Längs" bedeutet, dass die Zusatzelektrode oder ihre voneinander getrennten Teilbereiche nahezu parallel oder exakt parallel zu dem unteren Zonenrand verlaufen.

Ist die Zusatzelektrode oder ihre mindestens zwei voneinander getrennten Teilbereiche in der beschichtungsfreien Zone derart angeordnet, dass die Fläche zwischen dem Zonenrand des Heizfelds und der Zusatzelektrode oder ihrer Teilbereiche noch beschichtungsfrei ist, wird die elektrische Verbindung der Zusatzelektrode mit dem Heizfeldabschnitt mithilfe von mindestens zwei, vorzugsweise von mindestens drei, bevorzugt von mindestens vier und insbesondere von mindestens fünf Anschlussabschnitten bewerkstelligt. Ist die Zusatzelektrode in mindestens zwei, insbesondere zwei, voneinander getrennte Teilbereiche untergliedert, verfügt mindestens ein Teilbereich oder verfügen insbesondere alle Teilbereiche über mindestens zwei, vorzugsweise mindestens drei, bevorzugt mindestens vier und insbesondere mindestens fünf Anschlussabschnitte.

Die Anschlussabschnitte können die Form gerader oder Biegungen aufweisender Streifen haben, deren Länge größer als ihre Breite ist.

Die Anschlussabschnitte können aber auch von Ausbuchtungen und/oder Vorsprüngen der Zusatzelektrode oder ihrer Teilbereiche gebildet werden, wenn diese beispielsweise wellenförmig, zickzackförmig, sägezahnförmig oder mäanderförmig verläuft oder verlaufen, so dass sie das Heizfeld abschnittsweise berühren.

Die Anschlussabschnitte erstrecken sich von der Zusatzelektrode oder ihren voneinander getrennten Teilbereichen in den Heizfeldabschnitt des Heizfelds zwischen der Zusatz-elektrode oder ihren Teilbereichen und der entgegengesetzt elektrisch geladenen Sammelelektrode, insbesondere der im eingebauten Zustand der erfindungsgemäßen transparenten Scheibe unteren Sammelelektrode.

Vorzugsweise erfolgt die elektrische Verbindung der Zusatzelektrode oder der mindestens zwei voneinander getrennten Teilbereiche der Zusatzelektrode mit dem einen Pol der Spannungsquelle über eine der beiden Sammelelektroden, insbesondere über die im eingebauten Zustand der erfindungsgemäßen Scheibe obere Sammelelektrode.

In einer bevorzugten Ausführungsform der transparenten Scheibe führen von mindestens einer, insbesondere einer, der beiden Sammelelektroden mindestens zwei, insbesondere zwei, Stromversorgungsleitungen zu der mindestens einen, insbesondere einen, Zusatz-elektrode.

In einer weiteren bevorzugten Ausführungsform der transparenten Scheibe führen von mindestens einer, insbesondere einer, der beiden Sammelelektroden jeweils mindestens eine, insbesondere eine, Stromversorgungsleitung zu jedem der mindestens zwei, insbesondere zwei, Teilbereiche der Zusatzelektrode.

Für die Alternative (i) von Patentanspruch 1 führen von jedem der mindestens zwei, insbesondere zwei, Teilbereiche der Sammelelektrode jeweils mindestens eine, insbesondere eine, Stromversorgungsleitung zu der mindestens einen, insbesondere einen Zusatzelektrode. Für die Alternativen (ii) und (iii) von Patentanspruch 1 führen vorzugsweise von jedem der mindestens zwei, insbesondere zwei, Teilbereiche der Sammelelektrode jeweils mindestens eine, insbesondere eine, Stromversorgungsleitung zu der mindestens einen, insbesondere einen Zusatzelektrode.

Falls die mindestens eine Zusatzelektrode in mindestens zwei voneinander getrennte Teilbereiche untergliedert ist, gilt für die Alternative (i) von Patentanspruch 1, dass von jedem der mindestens zwei, insbesondere zwei, Teilbereiche der Sammelelektrode jeweils mindestens eine, insbesondere eine, Stromversorgungsleitung zu jedem der mindestens zwei, insbesondere zwei, Teilbereiche der Zusatzelektrode führen. Für die Alternativen (ii) und (iii) von Patentanspruch 1 gilt, dann vorzugsweise, dass von jedem der mindestens zwei, insbesondere zwei, Teilbereiche der Sammelelektrode jeweils mindestens eine, insbesondere eine, Stromversorgungsleitung zu jedem der mindestens zwei, insbesondere zwei, Teilbereiche der Zusatzelektrode führen.

In noch einer weiteren bevorzugten Ausführungsform der transparenten Scheibe führt von mindestens einer Sammelelektrode oder von mindestens einem Teilbereich mindestens einer Sammelelektrode eine Kopplungsleitung zu den Enden zweier, der Zusatzelektrode zugeordneter Stromversorgungsleitungen. Anders gesagt, verzweigt sich die Kopplungsleitung an einem Knotenpunkt in zwei Stromversorgungsleitungen, die zu den Enden der Zusatzelektrode oder zu jeweils einem Ende zweier Teilbereiche der Zusatzelektrode führen.

In noch einer weiteren bevorzugten Ausführungsform der transparenten Scheibe wird die elektrische Verbindung zwischen mindestens einer Sammelelektrode oder mindestens einem Teilbereich mindestens einer Sammelelektrode und mindestens einer Zusatzelektrode oder mindestens zwei Teilbereichen einer Zusatzelektrode durch die galvanische Kopplung über ein zwischen der betreffenden Sammelelektrode oder dem betreffenden Teilbereich mindestens einer Sammelelektrode einerseits und mindestens einer, insbesondere einer, Kopplungselektrode andererseits angeordnetes Koppelungsfeld des Heizfelds hergestellt. Die Kopplungselektrode verbindet jeweils ein Ende zweier Stromversorgungsleitungen, die zu den Enden einer Zusatzelektrode oder ich jeweils zu einem Ende eines Teilbereichs einer Zusatzelektrode führen. Somit ist bei dieser Konfiguration die zugeordnete erste beschichtungsfreie Zone von einer umlaufenden elektrischen Leitungsbahn aus Kopplungselektrode, zwei Stromversorgungsleitungen und einer Zusatzelektrode oder mindestens zwei Teilbereichen einer Zusatzelektrode umgeben.
Bei den vorstehend beschriebenen bevorzugten Ausführungsformen erfolgt die galvanische Verbindung oder Kopplung zwischen den Teilbereichen der Zusatzelektrode über den Heizfeldabschnitt des Heizfelds zwischen der Zusatzelektrode oder ihren Teilbereichen und der entgegengesetzt elektrisch geladenen Sammelelektrode, insbesondere der im eingebauten Zustand der erfindungsgemäßen transparenten Scheibe unteren Sammelelektrode.

Erfindungsgemäß ist oder sind mindestens eine Stromversorgungsleitung und insbesondere alle Stromversorgungsleitungen zumindest abschnittsweise
- im Heizfeld und/oder
- in mindestens einem Teilbereich der elektrisch leitfähigen Beschichtung außerhalb des Heizfelds, d.h. dem Bereich der elektrisch leitfähigen Beschichtung, der zwischen der Sammelelektrode oder ihren Teilbereichen und dem Scheibenrand, angeordnet ist, und/oder
- in mindestens einer Zone des Randstreifens im Bereich der elektrisch leitfähigen Beschichtung außerhalb des Heizfelds und/oder
- am und/oder im von der elektrisch leitfähigen Beschichtung gebildeten Zonenrand der mindestens einen, insbesondere einen, zweiten, beschichtungsfreien Zone und/oder
- in mindestens einer, insbesondere einer, der mindestens einen ersten beschichtungsfreien Zone oder der mindestens einen, insbesondere einen, zweiten beschichtungsfreien Zone zugeordnete Zone des Randstreifens und/oder auf
- in der mindestens einen, insbesondere einen, ersten beschichtungsfreien Zone und/oder
- in und/oder an mindestens einem seitlichen Zonenrand, insbesondere zwei seitlichen Zonenrändern, der mindestens einen, insbesondere einen, ersten beschichtungsfreien Zone
angeordnet.

In einer bevorzugten Ausführungsform verlaufen die mindestens zwei, insbesondere zwei, Stromversorgungsleitungen abschnittsweise
- in mindestens zwei, insbesondere zwei, Teilbereichen der elektrisch leitfähigen Beschichtung außerhalb des Heizfelds, d.h. außerhalb des Bereichs der elektrisch leitfähigen Beschichtung, der zwischen der Sammelelektrode oder ihren Teilbereichen und dem Scheibenrand, angeordnet ist, und/oder
- in mindestens zwei, insbesondere zwei, Zonen des Randstreifens im Bereich der elektrisch leitfähigen Beschichtung außerhalb des Heizfelds,
- innerhalb des von der elektrisch leitfähigen Beschichtung gebildeten Zonenrands der mindestens einen, insbesondere einen, zweiten, beschichtungsfreien Zone und
- im Heizfeld längs zweier seitlichen Zonenränder der mindestens einen, insbesondere einen, ersten beschichtungsfreien Zone.

Die Länge der Stromversorgungsleitungen kann breit variieren und daher hervorragend den Erfordernissen des Einzelfalls angepasst werden.

Desgleichen kann die Breite der Stromversorgungsleitungen breit variieren und ebenfalls hervorragend den Erfordernissen des Einzelfalls angepasst werden.

Die Stromversorgungsleitungen können abschnittsweise geradlinig, gebogen, wellenförmig, zickzackförmig, sägezahnförmig und/oder mäanderförmig verlaufen.

Vorzugsweise werden Länge und die Breite sowie die Form, insbesondere die Länge und die Breite, der Stromversorgungsleitungen im Einzelfall so ausgewählt, dass die Zusatz-elektrode oder ihre Teilbereiche eine solche Spannung aufweist oder aufweisen, dass sich in dem ihnen und der beschichtungsfreien Zone benachbarten Bereichen des Heizfelds und Heizfeldabschnitts der beheizbaren Beschichtung eine Temperatur einstellt, die nur geringfügig, vorzugsweise nur 5 bis 50 °C, insbesondere nur 5 bis 40 °C, und idealerweise gar nicht von der Temperatur der übrigen beheizten Beschichtung abweicht.

Genauer gesagt, wird einerseits durch die Länge der Zusatzelektrode oder ihrer Teilbereiche das elektrische Potenzial, insbesondere an der Verbindungsstelle zum Heizfeld so eingestellt, dass möglichst viel Strom über die Zusatzelektrode oder ihre Teilbereiche fließt. Andererseits darf nur so viel Strom fließen, dass die Zusatzelektrode oder ihre Teilbereiche und deren direkte Umgebung nicht überhitzten, um die Bildung von Hot Spots zu vermeiden. So könnte das elektrische Potenzial bzw. der elektrische Widerstand der Zusatzelektrode theoretisch auch nur über ihre Breite entsprechend angepasst werden. In diesem Fall käme es aber zu dem Problem, dass der gesamte Spannungsabfall nur über eine sehr kurze Zusatzelektrode abgebaut werden müsste, was zu einer Überhitzung der Zusatzelektrode oder ihrer Teilbereiche selbst führen würde.

Dieses Problem kann indes durch möglichst lange Stromversorgungsleitungen gelöst werden, die die Überhitzung verhindern.

Erfindungsgemäß bestehen die Stromversorgungsleitungen aus denselben elektrisch leitfähigen Materialien wie die Sammelelektroden.

Erfindungsgemäß wird die Bildung von Hot Spots noch wirksamer dadurch verhindert, dass im Heizfeld zumindest abschnittsweise längs mindestens einer Stromversorgungsleitung und insbesondere längs mindestens zweier, insbesondere zweier, Stromversorgungsleitungen mindestens eine beschichtungsfreie Linie und insbesondere mindestens zwei, insbesondere zwei, beschichtungsfreie Linien verläuft oder verlaufen. Dabei verlaufen die beschichtungsfreien Linien stets auf der der beschichtungsfreien Zone abgewandten Seite der Stromversorgungsleitungen.

Erfindungsgemäß verlaufen die beschichtungsfreien Linien zumindest abschnittsweise durchgehend und/oder als unterbrochene Linien diskreter Einschnitte. Vorzugsweise verlaufen sie in ihrer gesamten Länge durchgehend, d.h. ohne Einschnitte.

Bei einer weiteren erfindungsgemäßen Ausführungsform verlaufen die beschichtungsfreien Linien von einer Sammelelektrode aus durch das Heizfeld bis zur Höhe der Zusatzelektrode oder der Höhe der Teilbereiche der Zusatzelektrode und von da aus abschnittsweise durch den Heizfeldabschnitt längs der Zusatzelektrode oder längster Teilbereiche der Zusatz-elektrode.

Bei noch einer weiteren erfindungsgemäßen Ausführungsform beginnen die beschichtungsfreien Linien im Heizfeld in einem gewissen Abstand zur Sammelelektrode.

Vorzugsweise verlaufen die beschichtungsfreien Linien zumindest abschnittsweise geradlinig, wellenförmig, sägezahnförmig, mäanderförmig und/oder zickzackförmig. Bevorzugt verlaufen sie in ihrer gesamten Länge geradlinig längs der ihnen jeweils zugeordneten Stromversorgungsleitungen.

Die Länge der beschichtungsfreien Linien kann breit variieren und daher in vorteilhafter Weise den Erfordernissen des Einzelfalls angepasst werden. Insbesondere richtet sich ihre Länge nach der Länge der Abschnitte der ihnen jeweils zugeordneten Stromversorgungsleitungen im Heizfeld.

Die Breite der beschichtungsfreien Linien ist sehr viel kleiner als ihre Länge und kann in ihrem Verlauf variieren. Vorzugsweise ist die Breite auf dem ganzen Verlauf konstant. Vorzugsweise liegt die Breite im Bereich von 10 µm bis 1 mm.

Insgesamt wird durch die erfindungsgemäße Anordnung von Sammelelektrode, Zusatz-elektrode, Stromversorgungsleitungen und beschichtungsfreie Linien eine annähernd homogene Verteilung der Heizleistung bewirkt und die Bildung von Stellen mit verringerter oder erhöhter Heizleistung (Hot Spots) wirksam verhindert.

Somit kann auch durch die erfindungsgemäße Anordnung im Bereich der beschichtungsfreien Zone der erfindungsgemäßen transparenten Scheibe die Bildung von Rückständen aus Eis und/oder kondensiertem Wasser wirksam verhindert werden.

Die Sammelelektroden und/oder ihre Teilbereiche werden durch eine oder mehrere Zuleitungen elektrisch kontaktiert.

Die Zuleitung ist bevorzugt als flexibler Folienleiter oder Flachleiter oder Flachbandleiter ausgebildet. Darunter wird ein elektrischer Leiter verstanden, dessen Breite deutlich größer ist als seine Dicke. Ein solcher Flachleiter ist beispielsweise ein Streifen oder Band, enthaltend oder bestehend aus Kupfer, verzinntem Kupfer, Aluminium, Silber, Gold oder Legierungen davon. Der Flachleiter weist beispielsweise eine Breite von 2 mm bis 16 mm und eine Dicke von 0,03 mm bis 0,1 mm auf. Der Flachleiter kann eine isolierende, bevorzugt polymere Ummantelung, beispielsweise auf Polyimid-Basis aufweisen. Flachleiter, die sich zur Kontaktierung von elektrisch leitfähigen Beschichtungen in Scheiben eignen, weisen lediglich eine Gesamtdicke von beispielsweise 0,3 mm auf. Derart dünne Flachleiter können ohne Schwierigkeiten zwischen den einzelnen Scheiben in der thermoplastischen Zwischenschicht eingebettet werden. In einem Flachleiterband können sich mehrere voneinander elektrisch isolierte, leitfähige Schichten befinden.

Alternativ können auch dünne Metalldrähte als elektrische Zuleitung verwendet werden. Die Metalldrähte enthalten insbesondere Kupfer, Wolfram, Gold, Silber oder Aluminium oder Legierungen mindestens zweier dieser Metalle. Die Legierungen können auch Molybdän, Rhenium, Osmium, Iridium, Palladium oder Platin enthalten.

Bei einer bevorzugten Ausführungsform der erfindungsgemäßen transparenten Scheibe ist jeder der mindestens zwei, insbesondere zwei, Sammelelektroden mit jeweils einem Flachleiter mit den Polen der Spannungsquelle elektrisch leitend verbunden.

Bei einer weiteren bevorzugten Ausführungsform sind die mindestens zwei, insbesondere zwei, Teilbereiche der mindestens einen, insbesondere einen, Sammelelektrode mit jeweils einem an eine Spannungsquelle angeschlossenen Flachleiter elektrisch leitend verbunden. Vorzugsweise sind die Flachleiter in dem Bereich der Teilbereiche angeordnet, der der jeweils zugeordneten zweiten Seite des Scheibenrands nahe liegt. Bei dieser Ausführungsform erfolgt die elektrische Isolierung der Flachleiter von den Stromversorgungsleitungen durch die räumliche Trennung der Komponenten

In noch einer weiteren bevorzugten Ausführungsform sind die mindestens zwei, insbesondere zwei, Teilbereiche der mindestens einen, insbesondere einen Sammel-elektrode mit einem Flachleiter elektrisch leitend verbunden. Vorzugsweise ist bei dieser Ausführungsform der Flachleiter mittig zwischen den beiden einander gegenüberliegenden Enden der Teilbereiche angeordnet. Vorzugsweise wird dies durch ein gemeinsames elektrisch leitfähiges Verbindungsteil oder durch zwei, dem jeweiligen Teilbereich zugeordnete, elektrisch leitfähige Verbindungsteile bewerkstelligt. Der Flachleiter kann mit dem elektrisch leitfähigen Verbindungsteil durch einen flachen Metallstreifen, insbesondere Kupferstreifen, verbunden sein.

Dabei sind der Flachleiter und das mindestens eine Verbindungsteil sowie gegebenenfalls der flache Metallstreifen, insbesondere Kupferstreifen, von den mindestens zwei Stromversorgungsleitungen elektrisch isoliert angeordnet.

In diesem Falle wird die elektrische Isolierung zwischen dem Flachleiter und dem Verbindungsteil einerseits und den mindestens zwei Stromversorgungsleitungen andererseits mittels einer elektrisch isolierenden Schicht, insbesondere mittels einer streifenförmigen, elektrisch isolierenden Schicht, zwischen dem Flachleiter und dem Verbindungsteil einerseits und den mindestens zwei Stromversorgungsleitungen andererseits bewerkstelligt. Die elektrisch isolierende Schicht, insbesondere die streifenförmige, elektrisch isolierende Schicht, bedeckt zumindest die Kreuzungspunkte des Verbindungsteils mit den mindestens zwei Stromversorgungsleitungen. Sie kann aber auch an die beiden einander gegenüberliegenden Endkanten der Teilbereiche anstoßen.

Vorzugsweise weist diese Anordnung insgesamt einen schichtförmigen Aufbau aus den folgenden übereinander liegenden Schichten auf:
- eine Scheibe,
- von der Isolierung bedeckte Abschnitte der Stromversorgungsleitungen,
- den Stromversorgungsleitungen benachbarte Teilbereiche der Beschichtung außerhalb des Heizfelds, an deren Zonenränder die einander gegenüberliegenden Kanten der elektrisch isolierenden Schicht anstoßen; zugleich können diese Kanten an die einander gegenüberliegenden Endkanten der beiden Teilbereiche der Sammelelektrode anstoßen
- ein der elektrisch isolierenden Schicht aufliegender Flachleiter
- Teilbereiche der Sammelelektrode sowie
- das mit ihnen elektrisch verbundene Verbindungsteil.

Ein wesentlicher Vorteil dieser Anordnung ist, dass nur noch ein Flachleiter zur Versorgung von zwei Teilbereichen einer Sammelelektrode benötigt wird, was die Herstellung der erfindungsgemäßen transparenten Scheibe wesentlich vereinfacht.

In einer bevorzugten Ausführungsform der erfindungsgemäßen transparenten Scheibe sind die Bereiche, in denen die Sammelelektroden, der oder die Flachleiter, die Zusatz-elektrode oder die Zusatzelektroden, die Stromversorgungsleitungen sowie die beschichtungsfreien Zonen angeordnet sind, teilweise oder in Gänze durch übliche und bekannte, opake oder undurchsichtige Maskierungsstreifen optisch maskiert. Vorzugsweise sind die Maskierungsstreifen schwarz gefärbt. Vorzugsweise werden die Vorprodukte der Maskierungsstreifen durch Siebdruck auf die noch unbeschichteten Scheiben aufgetragen, wonach die aufgetragenen Schichten eingebrannt werden.

Die erfindungsgemäßen Scheiben können in üblicher und bekannter Weise hergestellt werden. Vorzugsweise werden sie mithilfe des erfindungsgemäßen Verfahrens hergestellt.

Das erfindungsgemäße Verfahren umfasst die folgenden Verfahrensschritte:
(A) Herstellen einer elektrisch leitfähigen Beschichtung
(B) Herstellen mindestens einer beschichtungsfreien Zone oder mindestens zweier, insbesondere zweier, beschichtungsfreier Zonen in der elektrisch leitfähigen Beschichtung und im Heizfeld;
(C) Ausbilden von
   (c1) mindestens zwei, insbesondere zwei, mit den beiden Polen einer Spannungsquelle verbundenen Sammelelektroden, die mit der elektrisch leitfähigen Beschichtung elektrisch verbunden sind, so dass durch Anlegen einer Speisespannung ein Heizstrom über ein zwischen den beiden Sammelelektroden befindliches Heizfeld fließt, und/oder
   (c2) mindestens zwei mit den beiden Polen einer Spannungsquelle verbundenen Sammelelektroden, die mit der elektrisch leitfähigen Beschichtung elektrisch verbunden sind wobei mindestens eine der beiden Sammelelektroden in mindestens zwei voneinander getrennte Teilbereiche untergliedert ausgeführt wird;
(D) Herstellen
   (d1) mindestens einer zum elektrischen Verbinden mit mindestens einer der beiden Sammelelektroden vorgesehenen Zusatzelektrode und/oder
   (d2) mindestens zweier, insbesondere zweier, zum elektrischen Verbinden mit mindestens einer der beiden, insbesondere beiden, Sammelelektroden vorgesehenen Teilbereiche der Zusatzelektrode und/oder
   (d3) mindestens einer, insbesondere einer, zum elektrischen Verbinden mit mindestens zwei voneinander getrennten Teilbereichen vorgesehenen Zusatzelektrode und/oder
   (d4) mindestens zweier, insbesondere zweier, zum elektrischen Verbinden mit jeweils mindestens einem, insbesondere einen, der mindestens zwei, insbesondere zwei, voneinander getrennten Teilbereiche vorgesehenen Teilbereiche der Zusatzelektrode;
(E) Herstellen mindestens zweier, insbesondere zweier, Stromversorgungsleitungen für die mindestens eine, insbesondere eine, Zusatzelektrode oder ihrer mindestens zwei, insbesondere zwei Teilbereiche,
   (e1) die von mindestens einer, insbesondere einer, der beiden Sammelelektroden zu der mindestens einen, insbesondere einen, Zusatzelektrode geführt werden,
   (e2) von denen jeweils mindestens eine, insbesondere eine, von jedem der mindestens zwei Teilbereiche zu der mindestens einen, insbesondere einen, Zusatzelektrode geführt wird,
   (e3) von denen jeweils mindestens eine, insbesondere eine, von mindestens einer, insbesondere einer, der beiden Sammelelektroden zu jedem der mindestens zwei, insbesondere zwei, Teilbereiche der Zusatzelektrode geführt wird und/oder
   (e4) von denen jeweils mindestens eine, insbesondere eine, von jedem der mindestens zwei, insbesondere zwei, Teilbereiche zu jedem der mindestens zwei, insbesondere zwei, Teilbereiche der Zusatzelektrode geführt wird,
   (e5) die beide mit einer Kopplungsleitung verbunden werden, die zu mindestens einer, insbesondere einer, der beiden Sammelelektroden oder zu mindestens einem der mindestens zwei Teilbereiche mindestens einer Sammelelektrode geführt wird, oder
   (e6) die beide mit einer Kopplungselektrode verbunden werden, die über ein zwischen der Kopplungselektrode einerseits und mindestens einer Sammelelektrode oder mindestens einem der mindestens zwei Teilbereiche mindestens einer Sammelelektrode andererseits im Heizfeld befindliches Koppelungsfeld mit der mindestens einen Sammelelektrode oder mindestens einem der mindestens zwei Teilbereiche mindestens einer Sammelelektrode elektrisch verbunden (d.h. galvanisch gekoppelt) wird, und
(F) Herstellen mindestens einer beschichtungsfreien Linie und insbesondere zweier beschichtungsfreier Linien im Heizfeld längs der der beschichtungsfreien Zone abgewandten Seite zumindest eines Abschnitts mindestens einer Stromversorgungsleitung und insbesondere zweier Stromversorgungsleitungen vor, während oder nach dem Verfahrensschritt (B), wobei
(G) die Verfahrensschritte (C), (D) und (E) nacheinander oder gleichzeitig durchgeführt werden.

Bei einer bevorzugten Ausführungsform des erfindungsgemäßen Verfahrens werden im Verfahrenschritt (E) wird oder werden mindestens eine Stromversorgungsleitung und insbesondere mindestens zwei, insbesondere zwei, Stromversorgungsleitungen (16, 16') zumindest abschnittsweise
- in mindestens einem Teilbereich und insbesondere in mindestens zwei Teilbereichen der elektrisch leitfähigen Beschichtung) außerhalb des Heizfelds und/oder
- in mindestens einer Zone und insbesondere in mindestens zwei, insbesondere zwei, Zonen des Randstreifens im Bereich der Zone des Beschichtungsrands und/oder
- unterhalb mindestens einer, insbesondere einer, elektrisch isolierenden Schicht, auf der ein Flachleiter und mindestens ein, insbesondere ein, gemeinsames Verbindungsteil und/oder mindestens zwei, insbesondere zwei, Verbindungsteile zwischen dem Flachleiter und den mindestens zwei, insbesondere zwei, Teilbereichen angeordnet werden, und/oder
- am und/oder im von der elektrisch leitfähigen Beschichtung gebildeten Zonenrand mindestens einer, insbesondere einer, zweiten beschichtungsfreien Zone und/oder
- im Heizfeld und/oder
- in der mindestens einen, insbesondere einen, ersten beschichtungsfreien Zone und/oder
- in und/oder an mindestens einem seitlichen Zonenrand und insbesondere an mindestens zwei, insbesondere zwei, seitlichen Zonenrändern der mindestens einen, insbesondere einen, ersten beschichtungsfreien Zone
verlaufend hergestellt.

Bei einer besonders bevorzugten Ausführungsform des erfindungsgemäßen Verfahrens werden die Verfahrensschritte (C), (D) und (E) gleichzeitig durchgeführt. Vorzugsweise wird hierbei ein Siebdruckverfahren verwendet.

Besonders bevorzugt werden die beschichtungsfreien Linien (21, 21') im Verfahrensschritt (F) durch Laserablation der elektrisch leitfähigen Beschichtung (8) des Heizfelds (12) hergestellt.

Im einzelnen kann das Aufbringen der elektrisch leitfähigen Beschichtung im Verfahrensschritt (A) durch an sich bekannte Verfahren erfolgen, bevorzugt durch magnetfeldunterstützte Kathodenzerstäubung. Das ist besonders vorteilhaft im Hinblick auf eine einfache, schnelle, kostengünstige und gleichmäßige Beschichtung der ersten Scheibe, wenn die erfindungsgemäße Scheibe als Verbundscheibe ausgestaltet ist. Die elektrisch leitfähige, beheizbare Beschichtung kann aber auch beispielsweise durch Aufdampfen, chemische Gasphasenabscheidung (chemical vapour deposition, CVD), plasmagestützte Gasphasenabscheidung (PECVD) oder durch nasschemische Verfahren aufgebracht werden.

Die erste Scheibe kann nach Verfahrensschritt (A) einer Temperaturbehandlung unterzogen werden. Dabei wird die erste Scheibe mit der elektrisch leitfähigen Beschichtung auf eine Temperatur von mindestens 200°C, bevorzugt mindestens 300°C erwärmt. Die Temperaturbehandlung kann der Erhöhung der Transmission und/oder der Verringerung des Flächenwiderstands der elektrisch leitfähigen Beschichtung dienen.

Die erste Scheibe kann nach Verfahrensschritt (A) gebogen werden, typischerweise bei einer Temperatur von 500 °C bis 700 °C. Da es technisch einfacher ist, eine plane Scheibe zu beschichten, ist dieses Vorgehen vorteilhaft, wenn die erste Scheibe gebogen werden soll. Alternativ kann die erste Scheibe aber auch vor Verfahrensschritt (A) gebogen werden, beispielsweise wenn die elektrisch leitfähige Beschichtung nicht dazu geeignet ist, einen Biegeprozess ohne Beschädigungen zu überstehen.

Das Aufbringen der Sammelelektroden in Verfahrensschritt (C) und der Stromversorgungsleitungen in Verfahrensschritt (E) erfolgt bevorzugt durch Aufdrucken und Einbrennen einer elektrisch leitfähigen Paste in einem Siebdruckverfahren oder in einem Inkjet-Verfahren. Alternativ können die Sammelelektroden und die Stromversorgungsleitungen als Streifen einer elektrisch leitfähigen Folie auf die elektrisch leitfähige Beschichtung aufgebracht, bevorzugt aufgelegt, angelötet oder angeklebt werden.

Bei Siebdruckverfahren erfolgt die laterale Formgebung durch die Maskierung des Gewebes, durch das die Druckpaste mit den Metallpartikeln gedrückt wird. Durch eine geeignete Formgebung der Maskierung kann beispielsweise die Breite der Sammel-elektrode besonders einfach vorgegeben und variiert werden.

Die beschichtungsfreien Zonen werden im Verfahrensschritte (B) bevorzugt durch mechanisches Abtragen der im Verfahrensschritt (A) hergestellten heizbaren Beschichtung hergestellt. Das mechanische Abtragen kann auch durch die Behandlung mit geeigneten Chemikalien und/oder durch die Bestrahlung mit elektromagnetischer Strahlung ersetzt oder ergänzt werden.

Eine vorteilhafte Weiterbildung des erfindungsgemäßen Verfahrens umfasst mindestens die folgenden weiteren Schritte:
- Anordnen einer thermoplastischen Zwischenschicht auf der beschichteten Oberfläche der ersten Scheibe und Anordnen einer zweiten Scheibe auf der thermoplastischen Zwischenschicht und
- Verbinden der ersten Scheibe und der zweiten Scheibe über die thermoplastische Zwischenschicht.

In diesen Verfahrensschritten wird die erste Scheibe so angeordnet, dass diejenige ihrer Oberflächen, welche mit der heizbaren Beschichtung versehen ist, der thermoplastischen Zwischenschicht zugewandt ist. Die Oberfläche wird dadurch zur innenseitigen Oberfläche der ersten Scheibe.

Die thermoplastische Zwischenschicht kann durch eine einzelne oder auch durch zwei oder mehrere thermoplastische Folien, die flächenmäßig übereinander angeordnet werden, ausgebildet werden.

Das Verbinden von erster und zweiter Scheibe erfolgt bevorzugt unter Einwirkung von Hitze, Vakuum und/oder Druck. Es können an sich bekannte Verfahren zur Herstellung einer Scheibe verwendet werden.

Es können beispielsweise sogenannte Autoklavverfahren bei einem erhöhten Druck von etwa 10 bar bis 15 bar und Temperaturen von 130 °C bis 145 °C über etwa 2 Stunden durchgeführt werden. An sich bekannte Vakuumsack- oder Vakuumringverfahren arbeiten beispielsweise bei etwa 200 mbar und 80 °C bis 110 °C. Die erste Scheibe, die thermoplastische Zwischenschicht und die zweite Scheibe können auch in einem Kalander zwischen mindestens einem Walzenpaar zu einer Scheibe gepresst werden. Anlagen dieser Art sind zur Herstellung von Scheiben bekannt und verfügen normalerweise über mindestens einen Heiztunnel vor einem Presswerk. Die Temperatur während des Pressvorgangs beträgt beispielsweise von 40 °C bis 150 °C. Kombinationen von Kalander- und Autoklavverfahren haben sich in der Praxis besonders bewährt. Alternativ können Vakuumlaminatoren eingesetzt werden. Diese bestehen aus einer oder mehreren beheizbaren und evakuierbaren Kammern, in denen die erste Scheibe und die zweite Scheibe innerhalb von beispielsweise etwa 60 Minuten bei verminderten Drücken von 0,01 mbar bis 800 mbar und Temperaturen von 80°C bis 170°C laminiert werden.

Die erfindungsgemäße transparente Scheibe, insbesondere die mithilfe des erfindungsgemäßen Verfahrens hergestellte erfindungsgemäße transparente Scheibe, wird als Einbauteil in Möbeln, Geräten und Gebäuden sowie in Fortbewegungsmitteln zur Fortbewegung auf dem Lande, in der Luft oder zu Wasser, insbesondere in Kraftfahrzeugen, beispielsweise als Windschutzscheibe, Heckscheibe, Seitenscheibe und/oder Glasdach verwendet. Vorzugsweise ist die erfindungsgemäße transparente Scheibe als Fahrzeug-Windschutzscheibe oder Fahrzeug-Seitenscheibe ausgeführt.

Es versteht sich, dass die vorstehend genannten und nachstehend näher erläuterten Merkmale nicht nur in den angegebenen Kombinationen und Konfigurationen, sondern auch in anderen Kombinationen und Konfigurationen oder in Alleinstellung einsetzbar sind, ohne den Rahmen der vorliegenden Erfindung zu verlassen.

Die Erfindung wird nun anhand von Ausführungsbeispielen näher erläutert, wobei Bezug auf die beigefügten Figuren genommen wird. Es zeigen in vereinfachter, nicht in maßstäblicher Darstellung:
- Figur 1: eine Draufsicht auf eine beispielhafte Ausgestaltung der erfindungsgemäßen Windschutzscheibe in vereinfachter Darstellung;
- Figur 2: eine Darstellung eines vertikalen Schnitts durch einen Ausschnitt der erfindungsgemäßen Windschutzscheibe gemäß der Figur 1;
- Figur 3: eine perspektivische Schnittdarstellung eines Ausschnitts der Windschutzscheibe gemäß der Figur 1;
- Figur 4: eine Draufsicht auf einen detaillierten Ausschnitt aus der beispielhaften Ausgestaltung der erfindungsgemäßen Windschutzscheibe gemäß der Figur 1;
- Figur 5: eine Darstellung eines vertikalen Schnitts durch einen Ausschnitt aus der erfindungsgemäßen Windschutzscheibe gemäß der Figur 4;
- Figur 6: eine Draufsicht auf eine weitere Windschutzscheibe in vereinfachter Darstellung, welche nicht in den Patentansprüchen beansprucht ist;
- Figur 7: eine Draufsicht auf eine weitere beispielhafte Ausgestaltung der erfindungsgemäßen Windschutzscheibe in vereinfachter Darstellung;
- Figur 8: eine Draufsicht auf noch eine weitere beispielhafte Ausgestaltung der erfindungsgemäßen Windschutzscheibe in vereinfachter Darstellung;
- Figur 9: eine Draufsicht auf eine weitere Ausgestaltung der Windschutzscheibe in vereinfachter Darstellung, welche nicht in den Patentansprüchen beansprucht ist;
- Figur 10: eine Draufsicht auf noch eine weitere beispielhafte Ausgestaltung der erfindungsgemäßen Windschutzscheibe in vereinfachter Darstellung;
- Figur 11: eine Draufsicht auf noch eine weitere beispielhafte Ausgestaltung der erfindungsgemäßen Windschutzscheibe in vereinfachter Darstellung;
- Figur 12: eine Draufsicht auf noch eine weitere beispielhafte Ausgestaltung der erfindungsgemäßen Windschutzscheibe in vereinfachter Darstellung.

### Kurze Beschreibung der Figuren

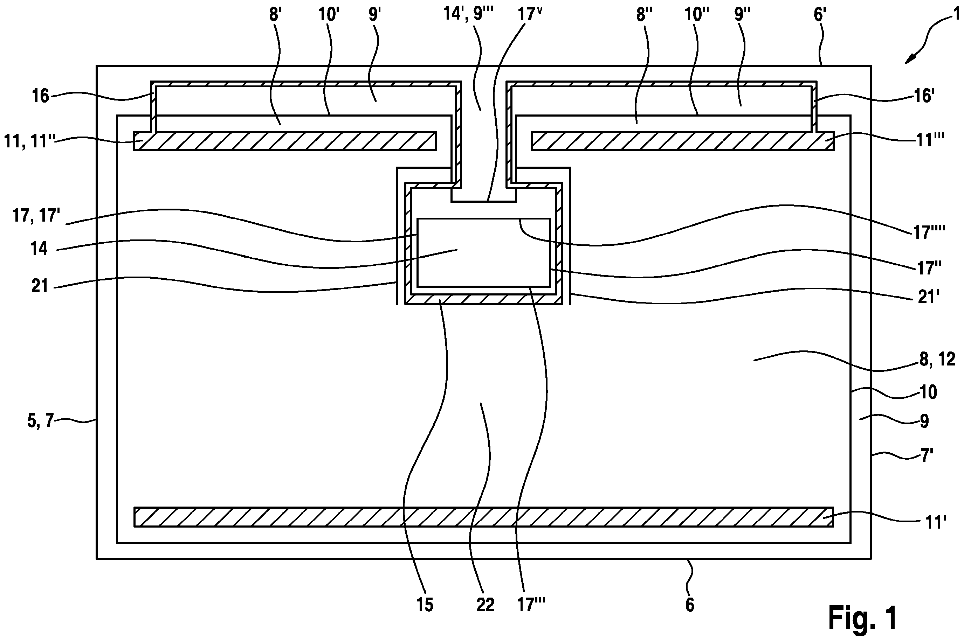

In den Figuren 1 bis 12 haben die Bezugszeichen die folgende Bedeutung:
- 1: Windschutzscheibe
- 2: Außenscheibe
- 3: Innenscheibe
- 4: Klebeschicht
- 5: Scheibenrand
- 6, 6': erste Seite
- 7, 7': zweite Seite
- 8: elektrisch leitfähige Beschichtung
- 8', 8": Teilbereich der elektrisch leitfähigen Beschichtung 8 außerhalb des Heizfelds 12
- 9: Randstreifen
- 9': Zone des Randstreifens 9 im Bereich der Zone 10' des Beschichtungsrands 10
- 9": Zone des Randstreifens 9 im Bereich der Zone 10" des Beschichtungsrands 10
- 9''': der ersten beschichtungsfreien Zone 14 zugeordnete Zone des Randstreifens 9
- 10: Beschichtungsrand
- 10', 10": Zone des Beschichtungsrands 10 im Bereich oberhalb der Teilbereiche der 11", 11''' der Sammelelektrode 11
- 11, 11': Sammelelektrode
- 11", 11''': Teilbereich der Sammelelektrode 11 oder 11'
- 12: Heizfeld
- 12': Kopplungsfeld
- 13: Maskierungsstreifen
- 13': Rand des Markierungsstreifens
- 14: erste beschichtungsfreie Zone
- 14': zweite beschichtungsfreie Zone
- 14": Teil der beschichtungsfreien Zone 14 oberhalb der Sammelelektrode 11
- 15: Zusatzelektrode
- 16, 16': Stromversorgungsleitung
- 16": Kopplungsleitung zwischen Sammelelektrode 11 und Stromversorgungsleitungen 16, 16'
- 16'": Kopplungselektrode
- 17: von der elektrisch leitfähigen Beschichtung 8 gebildeter Zonenrand der ersten beschichtungsfreien Zone 14
- 17', 17": im eingebauten Zustand der Windschutzscheibe 1 seitlicher, von der elektrisch leitfähigen Beschichtung 8 gebildeter Zonenrand der ersten beschichtungsfreien Zone 14
- 17"': im eingebauten Zustand der Windschutzscheibe 1 unterer, von der elektrisch leitfähigen Beschichtung 8 gebildeter Zonenrand der ersten Scheißtuner KL normal beschichtungsfreien Zone 14
- 17"": im eingebauten Zustand der Windschutzscheibe 1 oberer, von der elektrisch leitfähigen Beschichtung 8 gebildeter Zonenrand der ersten beschichtungsfreien Zone 14
- 17^{v}: von der elektrisch leitfähigen Beschichtung 8 gebildeter Zonenrand der zweiten beschichtungsfreien Zone 14'
- 18: mit einem Pol einer Spannungsquelle verbundener Flachleiter
- 19, 19': elektrisch isolierende Schicht
- 20, 20': Verbindungsteil zwischen Flachleiter 18 und Sammelelektrode 11, 11'
- 21, 21': beschichtungsfreie Linie
- 22: Heizfeldabschnitt des Heizfeldes 12 zwischen Zusatzelektrode 15 und einer zweiten Sammelelektrode 11 oder 11'

### Ausführliche Beschreibung der Figuren

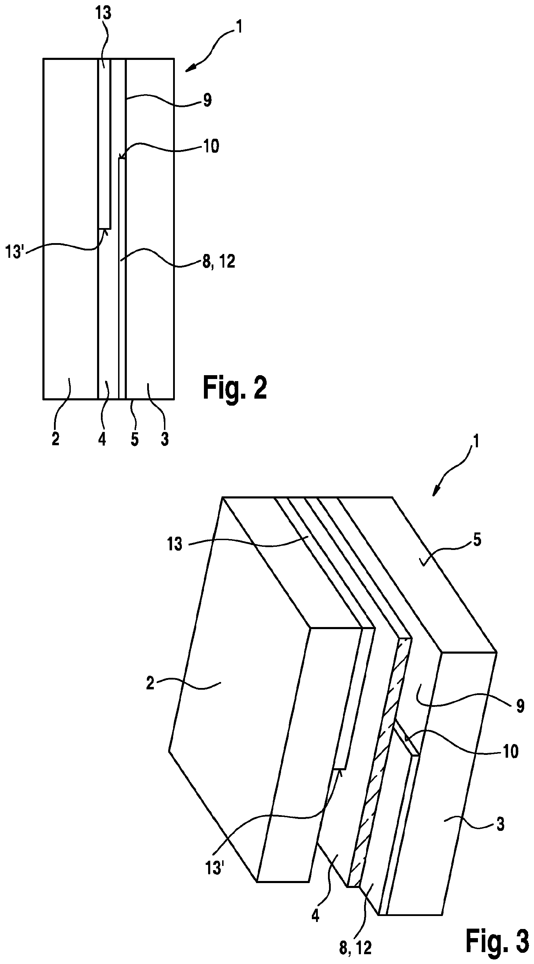

### Figur 1 in Verbindung mit den Figuren 2, 3 und 5

Die Figur 1 zeigt eine transparente Windschutzscheibe 1 eines Kraftfahrzeugs von der Innenseite her gesehen in vereinfachter Darstellung. Die Windschutzscheibe 1 ist hier beispielsweise als Verbundglasscheibe ausgeführt, deren Aufbau anhand der Darstellung eines vertikalen Schnitts durch einen Ausschnitt der Windschutzscheibe 1 in der Figur 2 und anhand der perspektivischen Schnittdarstellung eines Ausschnitts der Windschutzscheibe 1 in der Figur 3 veranschaulicht wird.

Demnach umfasst die Windschutzscheibe 1 zwei starre Einzelscheiben, nämlich eine Außenscheibe 2 und eine Innenscheibe 3, die durch eine thermoplastische Klebeschicht 4, hier beispielsweise eine Polyvinylbutyralfolie (PVB), eine Ethylen-Vinylacetat-Folie (EVA) oder eine Polyurethanfolie (PU), haftfest miteinander verbunden sind. Die beiden Einzelscheiben 2, 3 sind in etwa von gleicher Größe und Form und können beispielsweise eine trapezförmig geschwungene Kontur haben, was in den Figuren nicht näher dargestellt ist. Sie sind beispielsweise aus Glas gefertigt, wobei sie auch aus einem nichtgläsernen Material wie Kunststoff aufgebaut sein können. Für andere Anwendungen als Windschutzscheiben wäre es auch möglich, die beiden Einzelscheiben 2, 3 aus einem flexiblen Material herzustellen. Die Kontur der Windschutzscheibe 1 ergibt sich durch einen den beiden Einzelscheiben 2, 3 gemeinsamen Scheibenrand 5, wobei die Windschutzscheibe 1 oben und unten über zwei einander gegenüber liegende erste Seiten 6, 6' sowie links und rechts über zwei einander gegenüberliegende zweite Seiten 7, 7' verfügt.

Wie in den Figuren 2 und 3 dargestellt, ist auf der mit der Klebeschicht 4 verbundenen Seite der Innenscheibe 3 eine transparente, elektrisch leitfähige Beschichtung 8 abgeschieden. Die beheizbare, elektrisch leitfähige Beschichtung 8 ist hier beispielsweise im Wesentlichen vollflächig auf der Innenscheibe 3 aufgebracht, wobei ein allseitig umlaufender Randstreifen 9 nicht beschichtet ist, so dass ein Beschichtungsrand 10 der elektrisch leitfähigen Beschichtung 8 gegenüber dem Scheibenrand 5 nach innen rückversetzt ist. Hierdurch wird eine elektrische Isolierung der elektrisch leitfähigen Beschichtung 8 nach außen bewirkt. Zudem wird die elektrisch leitfähige Beschichtung 8 gegen vom Scheibenrand 5 vordringende Korrosion geschützt.

Die elektrisch leitfähige Beschichtung 8 umfasst in bekannter Weise eine nicht dargestellte Schichtenfolge mit mindestens einer elektrisch beheizbaren, metallischen Teilschicht, vorzugsweise Silber, und gegebenenfalls weiteren Teilschichten wie Entspiegelungs- und Blockerschichten. Vorteilhaft ist die Schichtenfolge thermisch hoch belastbar, so dass sie die zum Biegen der Glasscheiben erforderlichen Temperaturen von typischerweise mehr als 600 °C ohne Beschädigung übersteht, wobei aber auch thermisch gering belastbare Schichtenfolgen vorgesehen sein können. Die elektrisch leitfähige Beschichtung 8 kann gleichermaßen als metallische Einzelschicht aufgebracht sein. Ebenso ist denkbar, die elektrisch leitfähige Beschichtung 8 nicht direkt auf die Innenscheibe 3 aufzubringen, sondern diese zunächst auf einem Träger, beispielsweise eine Kunststofffolie, aufzubringen, der anschließend mit der Außen- und Innenscheibe 2, 3 verklebt wird. Alternativ kann die Trägerfolie mit Klebefolien (z.B. PVB-Folien) verbunden und als Dreischichtenanordnung (Trilayer) mit Innen- und Außenscheibe 2, 3 verklebt werden. Die beheizbare, elektrisch leitfähige Beschichtung 8 wird vorzugsweise durch Sputtern oder Magnetron-Kathodenzerstäubung auf die Innen- oder Außenscheibe 2, 3 aufgebracht.

Wie in der Figur 1 dargestellt, ist die elektrisch leitfähige Beschichtung 8 angrenzend an die ersten Seiten 6, 6', d.h. am oberen und unteren Scheibenrand 5, mit einer bandförmigen oberen Sammelelektrode oder Busbar 11 und einer bandförmigen unteren Sammelelektrode 11' elektrisch leitend verbunden und zu diesem Zweck mit den beiden Sammelelektroden 11, 11' beispielsweise galvanisch gekoppelt. Die obere Sammel-elektrode 11 ist zur Verbindung mit dem einen Pol einer nicht dargestellten Spannungsquelle vorgesehen. Die beiden Sammelelektroden 11, 11' gegensätzlicher Polarität dienen für eine gleichmäßige Einleitung und Verteilung des Heizstroms in das zwischen ihnen befindliche Heizfeld 12 der beheizbaren Beschichtung 8. Die beiden Sammelelektroden 11, 11' sind beispielsweise auf die elektrisch leitfähige Beschichtung 8 gedruckt und haben jeweils einen zumindest annähernd geradlinigen Verlauf.

Vorzugsweise ist die obere Sammelelektrode 11 in zwei voneinander getrennte Teilbereiche 11" und 11''' untergliedert.

Von jedem der beiden Teilbereiche 11", 11''' verlaufen jeweils eine Stromversorgungsleitung 16, 16' zu einer Zusatzelektrode 15. Dabei verlaufen die Stromversorgungsleitungen 16, 16' auf einer kurzen Strecke durch die außerhalb der Heizschicht 12 gelegenen Teilbereiche 8', 8" oberhalb der beiden Teilbereiche 11" und 11'''. Danach verlaufen die Stromversorgungsleitungen 16, 16' auf einer längeren Strecke durch die an die obere erste Seite 6' der Windschutzscheibe 1 angrenzenden beschichtungsfreien Zonen 9', 9" des beschichtungsfreien Randstreifen 9 im Bereich der Zonen 10', 10" des Beschichtungsrands 10 bis zur oberen, zweiten beschichtungsfreien Zone 14', die mit den beschichtungsfreien Zonen 9', 9" eine gemeinsame beschichtungsfreie Zone 14', 9', 9" bildet.

Von dort laufen die beiden Stromversorgungsleitungen 16, 16' innerhalb der beschichtungsfreien Zone 14', 9', 9" längs der von der elektrisch leitfähigen Beschichtung 8 gebildeten seitlichen Zonenränder 17^{V} bis in den unteren Bereich der zweiten beschichtungsfreien Zone 14'. Von dort aus überqueren sie die seitlichen Zonenränder 17^{V} und führen weiter über das Heizfeld 12 der elektrisch leitfähigen Beschichtung 8.

Unterhalb der oberen, zweiten beschichtungsfreien Zone 14' ist eine untere, erste beschichtungsfreie Zone 14 mit einem von der elektrisch leitfähigen Beschichtung 8 gebildeten Zonenrand 17 angeordnet. Der Zonenrand 17 besteht aus zwei seitlichen Zonenrändern 17', 17", einem unteren, der Zusatzelektrode 15 zugeordneten Zonenrand 17''' und einem oberen, der zweiten beschichtungsfreien Zone 14' zugeordneten Zonenrand 17"".

Die Stromversorgungsleitungen 16, 16' verlaufen weiter im Heizfeld 12 längs der seitlichen Zonenränder 17', 17", wobei die Stromversorgungsleitung 16 dem seitlichen Zonenrands 17' und die Stromversorgungsleitung 16' dem seitlichen Zonenrand 17" zugeordnet ist. Sie enden an den beiden seitlichen Enden der dem unteren Zonenrand 17''' zugeordneten Zusatzelektrode 15.

Die Zusatzelektrode 15 ist mit dem Heizfeldabschnitt 22 des Heizfelds 12 zwischen der Zusatzelektrode 15 und der unteren Sammelelektrode 11' galvanisch gekoppelt.

Die beschichtungsfreien Zonen 14, 14' haben hier beispielsweise eine zumindest annähernd rechteckige Kontur. Sie sind zumindest für einen Teil des elektromagnetischen Spektrums (z.B. IR-Strahlung, Funkwellen im Ultrakurz-, Kurz- und Langwellenbereich) durchlässig, um einen reibungslosen Datenverkehr durch die Windschutzscheibe 1 zu ermöglichen. Die beschichtungsfreien Zone 14, 14' können beispielsweise durch vorheriges Maskieren beim Aufbringen der elektrisch leitfähigen Beschichtung 8 auf die Innenscheibe 3 hergestellt werden. Alternativ kann sie nach Aufbringen der elektrisch leitfähigen Beschichtung 8 auch durch chemischen und/oder mechanischen Abtrag beispielsweise mittels Ätzen oder Einsatz eines Reibrads hergestellt werden.

Die Teilbereiche 11", 11''', die untere Sammelelektrode 11', die Zusatzelektrode 15 und die Stromversorgungsleitungen 16, 16' können durch Aufdrucken beispielsweise mittels eines Siebdruckverfahrens, einer metallischen Druckpaste, beispielsweise Silberdruckpaste, auf die Teilbereiche 8', 8" der elektrisch leitfähigen Beschichtung 8, den beschichtungsfreien Randstreifen 9 und die beschichtungsfreien Zonen 14, 14' vorzugsweise in einem Verfahrensschritt hergestellt werden.

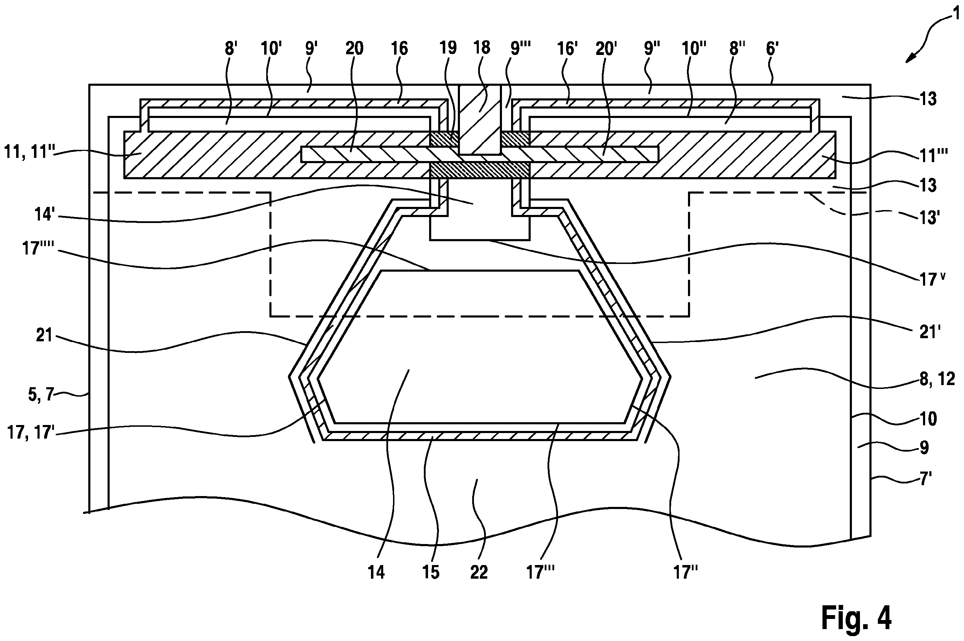

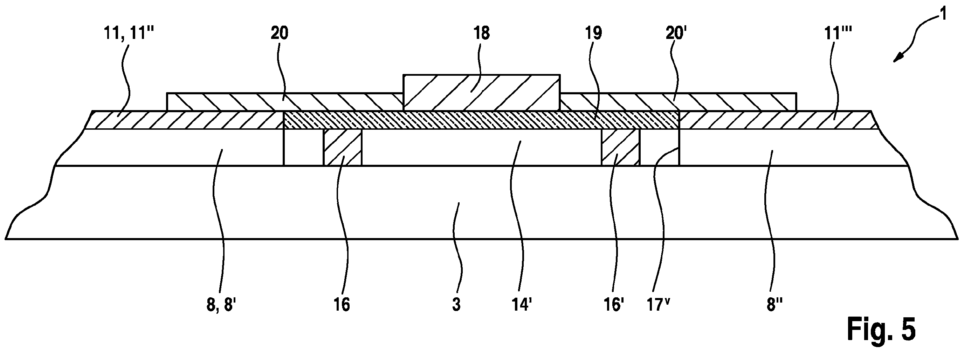

Die elektrische Verbindung der beiden Teilbereiche 11", 11''' mit dem einen Pol der nicht gezeigten Spannungsquelle wird über ein hier nicht gezeigtes gemeinsames, elektrisch leitfähiges, metallisches Verbindungsteil 20, das die beiden Teilbereiche 11", 11''' mit einem üblichen und bekannten Flachleiter 18 verbindet, hergestellt. Die Anordnung aus Flachleiter 18 und Verbindungsteil 20 wird durch eine hier nicht gezeigte streifenförmige, elektrisch isolierende Schicht 19 von den darunter verlaufenden Abschnitten der Stromversorgungsleitungen 16, 16' elektrisch isoliert. Die streifenförmige, elektrisch isolierende Schicht 19 verläuft zwischen den beiden Teilbereichen 11", 11''' und kann an deren Endkanten anstoßen. Zumindest aber bedeckt sie die Kreuzungspunkte der Stromversorgungsleitungen 16, 16' mit dem hier nicht gezeigten Verbindungsteil 20. Zu weiteren Details wird auf die Figuren 4 und 5 verwiesen.

Erfindungsgemäß verlaufen längs der Abschnitte der beiden Stromversorgungsleitungen 16, 16' im Heizfeld 12 in einem konstanten geringen Abstand hiervon jeweils eine durch Laserablation hergestellte, durchgehende, beschichtungsfreie Linie 21, 21' einer konstanten Breite von 500 µm bis zu den beiden seitlichen Enden der Zusatzelektrode 15.

Durch die erfindungsgemäße Anordnung der Stromversorgungsleitungen 16, 16' und der beschichtungsfreien Linien 21, 21' wird bei der erfindungsgemäßen transparenten Scheibe 1 gemäß der Figur 1 die Bildung von Hot Spots beim Anlegen einer Speisespannung und bei längerem Betrieb wirksam verhindert.

### Figur 4 in Verbindung mit der Figur 5

Die Figur 4 zeigt die Draufsicht auf einen detaillierten Ausschnitt aus der beispielhaften Ausgestaltung der erfindungsgemäßen Windschutzscheibe 1 gemäß der Figur 1.

Der Ausschnitt zeigt den oberen Bereich der erfindungsgemäßen Windschutzscheibe 1 gemäß der Figur 1. Im Unterschied zu der Figur 1 hat die untere, erste beschichtungsfreie Zone 14 eine verzerrt sechseckige Kontur. Erfindungsgemäß folgen die zugeordneten Abschnitte der Stromversorgungsleitungen 16, 16' und die ihnen zugeordneten durchgehenden, beschichtungsfreien Linien 21, 21' dieser Kontur.

Außerdem ist die mittig zwischen den beiden seitlichen Kanten der Teilbereiche 11", 11''' in der oberen, zweiten beschichtungsfreien Zone 14' angeordnete Anordnung aus Flachleiter 18, elektrisch leitfähigem Verbindungsteil 20, elektrisch isolierendem Streifen 19 und zugeordneten Abschnitten der beiden Stromversorgungsleitungen 16, 16' eingezeichnet.

Diese Anordnung wird noch einmal anhand der Figur 5 weiter veranschaulicht. Die Figur 5 zeigt einen vertikalen Schnitts durch die Anordnung im Bereich der oberen, zweiten beschichtungsfreien Zone 14' aus Innenscheibe 3, Teilbereichen 8', 8" der elektrisch leitfähigen Beschichtung 8 mit den Zonenrändern 17^{V}, Teilbereichen 11", 11''', elektrisch isolierendem Streifen 19, aufliegendem Flachleiter 18 und angrenzenden Teilbereichen 20, 20' des Verbindungsteils 20.

In einer weiteren Ausführungsform stößt die streifenförmige, elektrisch isolierende Schicht nicht an die Endkanten der Teilbereiche 11", 11''' an, sondern bedeckt nur die Kreuzungspunkte der Stromversorgungsleitungen 16, 16' mit den Verbindungsteilen 20, 20'.

Die Bereiche der Windschutzscheibe 1, worin sich die vorstehend beschriebenen funktionalen Elemente befinden, sowie Teile des Heizfelds 12 werden durch schwarze, opake Maskierungsstreifen 13 mit dem Rand 13' verdeckt und dadurch optisch maskiert.

Die Maskierungsstreifen dienen auch der Abschirmung von UV-Strahlung, die die Funktionen der elektrisch leitfähigen Elemente beeinträchtigen könnte.

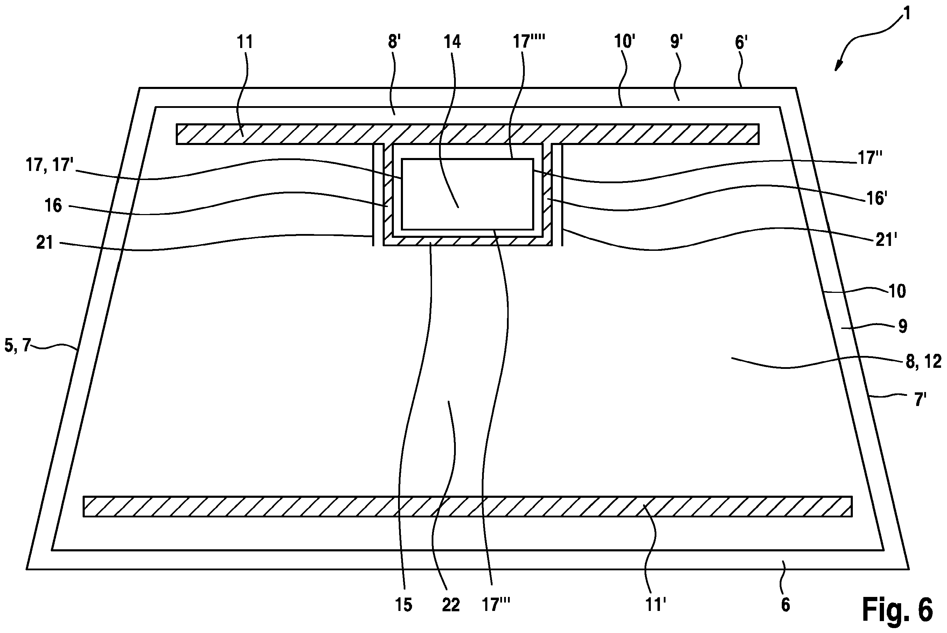

### Figuren 6 bis 12 in Verbindung mit den Figuren 2 und 3

Die Figuren 6 bis 12 zeigen weitere vorteilhafte Ausgestaltungen der Windschutzscheibe 1 in vereinfachter Darstellung.

Bei der vereinfachten Darstellung werden einige Merkmale, die in den Figuren 1, 4 und 5 näher dargestellt sind, der besseren Übersichtlichkeit halber weggelassen, so dass die die Ausführungsformen gemäß den Figuren 6 bis 12 hauptsächlich charakterisierenden Merkmale stärker hervortreten.

Der in der Praxis üblicherweise verwendete Umriss der Windschutzscheibe 1 wird durch die Trapezform der Windschutzscheibe 1 gemäß den Figuren 6 bis 12 angedeutet.

Die Windschutzscheiben 1 gemäß den Figuren 6 bis 12 weisen ebenfalls den in den Figuren 2 und 3 dargestellten Aufbau auf. Sie sind aus den gleichen Materialien wie die Windschutzscheiben gemäß den Figuren 1 und 4 aufgebaut.

Im Folgenden kann sich daher die Beschreibung der Windschutzscheiben 1 gemäß den Figuren 6 bis 12 auf die jeweiligen hauptsächlich charakterisierenden Merkmale beschränken.

### Figur 6

Die Windschutzscheibe 1 gemäß der Figur 6 weist eine durchgehende Sammelelektrode 11 auf. Unterhalb der Sammelelektrode 11 ist im Heizfeld 12 die (erste) beschichtungsfreie Zone 14 mit den Zonenrändern 17 mittig angeordnet. Von der Sammelelektrode 11 zweigen zwei Stromversorgungsleitungen 16, 16' ab und verlaufen im Heizfeld 12 längs der seitlichen Zonenränder 17', 17" bis zur Zusatzelektrode 15, die sich längs des unteren Zonenrands 17''' im Heizfeld 12 erstreckt und in elektrischem Kontakt mit dem Heizfeldabschnitt 22 steht.

Längs der Stromversorgungsleitungen 16, 16' verlaufen auf deren den seitlichen Zonenrändern 17', 17"abgewandten Seiten jeweils eine durchgehende beschichtungsfreie Linie 21,21' von der Sammelelektrode bis zur Höhe der Zusatzelektrode 15.

### Figur 7

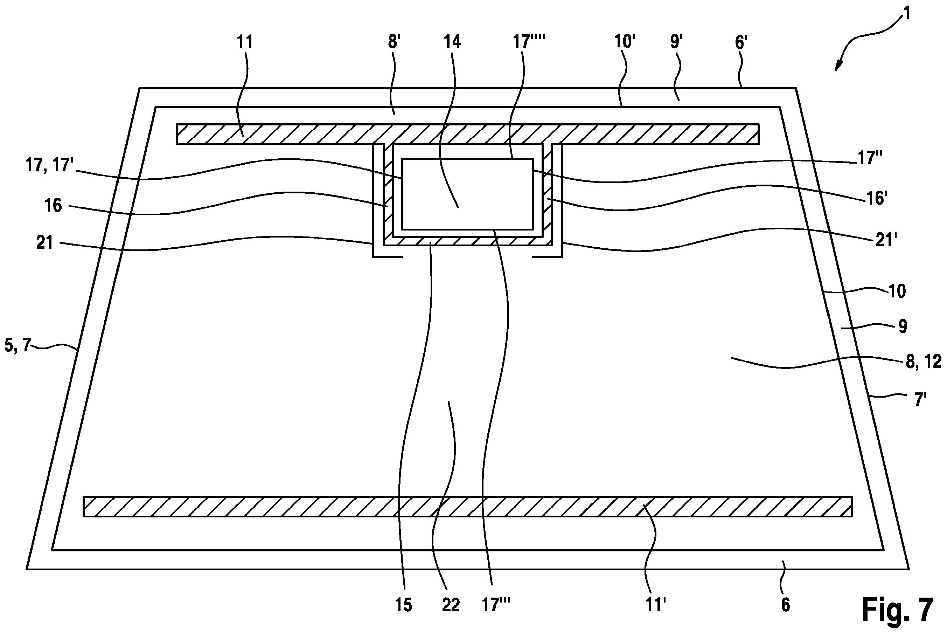

Die Windschutzscheibe 1 gemäß der Figur 7 unterscheidet sich von der der Figur 6 lediglich darin, dass die durchgehenden beschichtungsfreien Linien 21, 21' im Heizfeldabschnitt 22 jeweils noch eine kurze Strecke längs der Zusatzelektrode 15 verlaufen.

### Figur 8

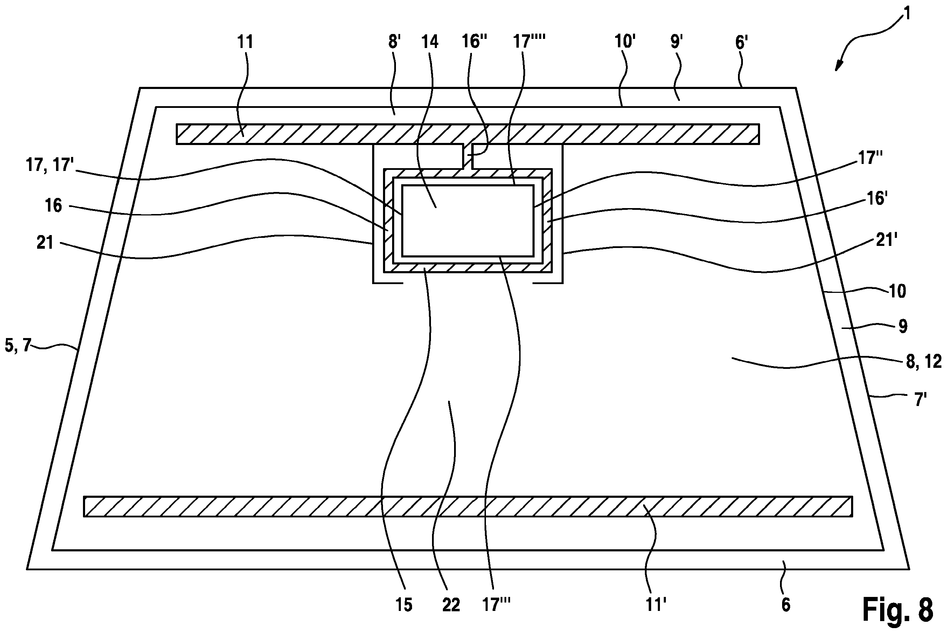

Die Windschutzscheibe 1 gemäß der Figur 8 weist ebenfalls eine durchgehende Sammelelektrode 11 auf. Unterhalb der Sammelelektrode 11 ist gleichfalls eine (erste) beschichtungsfreie Zone 14 mittig angeordnet. Im Unterschied zu der Windschutzscheibe gemäß der Figur 7 zweigt von der Mitte der Sammelelektrode die Kopplungsleitung 16" ab, die die Stromversorgungsleitungen, die um die Zonenränder 17"", 17' und 17" bis zur Zusatzelektrode 15 geführt sind, mit Strom versorgt. Die Konfiguration der durchgehenden beschichtungsfreien -Linien 21, 21' entspricht derjenigen der Windschutzscheibe 1 gemäß der Figur 7.

### Figur 9

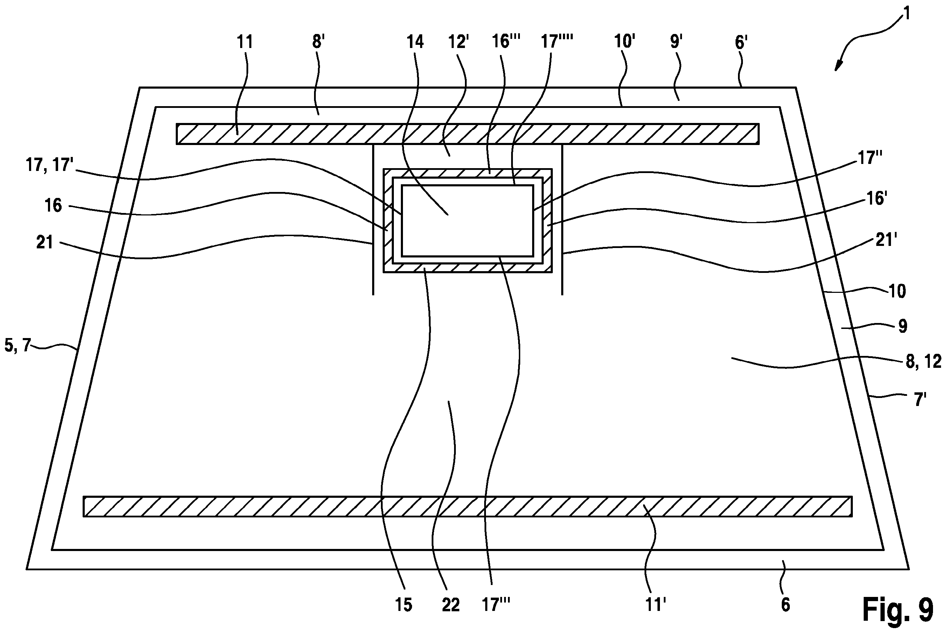

Die Windschutzscheibe 1 gemäß der Figur 9 weist gleichfalls eine durchgehende Sammelelektrode 11 auf. Im Unterschied zu der Windschutzscheibe 1 gemäß der Figur 8 weist sie keine Kopplungsleitung 16" auf, sondern der elektrische Kontakt oder die galvanische Kopplung zwischen der Sammelelektrode 11 und der Stromversorgungsleitungen 16, 16' wird mittels einer parallel zur Sammelelektrode 11 verlaufenden Kopplungselektrode 16'" und einem dazwischen angeordneten Koppelungsfeld 12' im Heizfeld 12 hergestellt. Die Kopplungselektrode 16''' verläuft längs des oberen Zonenrands 17"" der (ersten) beschichtungsfreien Zone 14 im Heizfeld 12. Die beiden Stromversorgungsleitungen 16, 16' verlaufen im Heizfeld 12 längs der seitlichen Zonenränder 17', 17" bis zu der längs des unteren Zonenrands 17''' im Heizfeld 12 verlaufenden Zusatzelektrode 15.

Die beiden durchgehenden beschichtungsfreien Linien 21, 21' sind wie bei der Windschutzscheibe 1 gemäß Figur 6 angeordnet, nur dass sie sich noch eine gewisse Strecke in den Heizfeldabschnitt 22 erstrecken.

### Figur 10

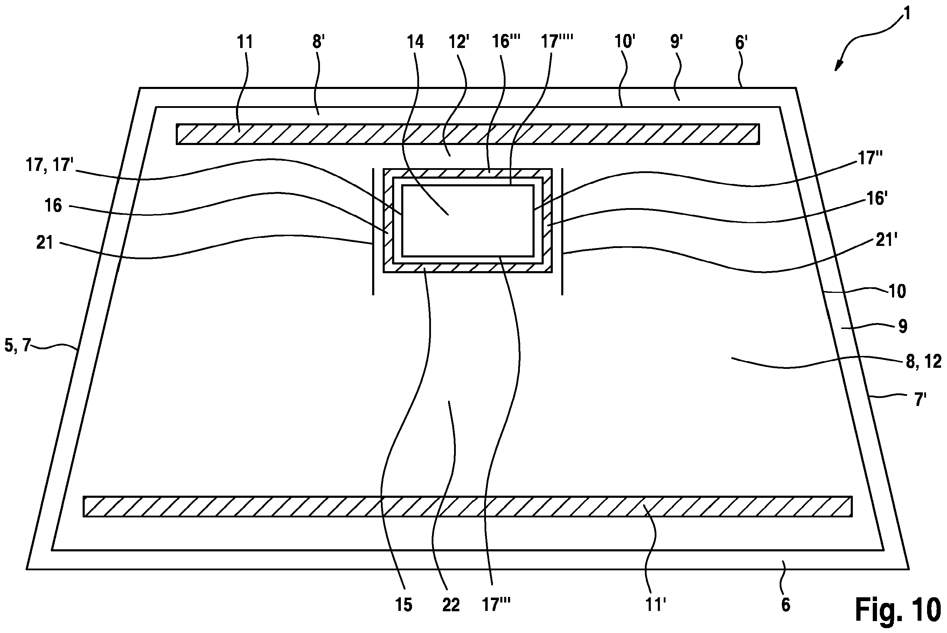

Die Konfiguration der Windschutzscheibe 1 gemäß Figur 10 entspricht derjenigen von Figur 9, nur dass die durchgehenden beschichtungsfreien Linien 21, 21' nicht bei der Sammelelektrode 11, sondern auf der Höhe der Kopplungselektrode 16'" beginnen.

### Figur 11

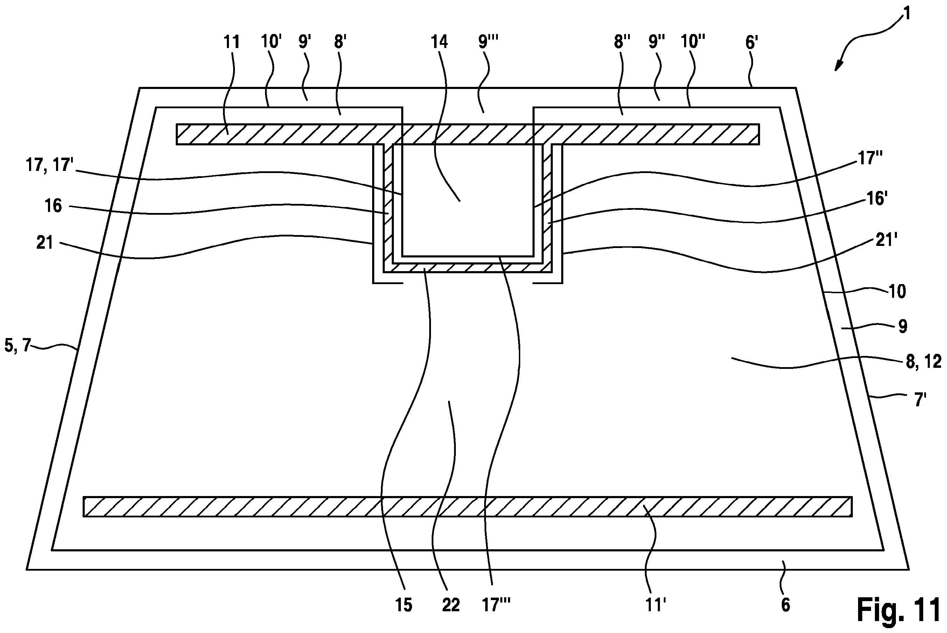

Die Windschutzscheibe 1 gemäß Figur 11 weist ebenfalls eine durchgehende Sammel-elektrode 11 auf. Im Unterschied zu den Windschutzscheiben 1 gemäß den Figuren 6 bis 10 weist sie mittig eine (erste) beschichtungsfreie Zone 14 auf, die mit dem ihr zugeordneten beschichtungsfreien Randstreifen 9"' eine einheitliche beschichtungsfreie Zone bildet. Die Sammelelektrode 11 ist durch diese beschichtungsfreie Zone geführt, so dass oberhalb der Sammelelektrode 11 die sich außerhalb des Heizfelds 12 befindlichen Teilbereiche 8', 8"der elektrisch leitfähigen Beschichtung 8 mit den ihnen zugeordneten Zonen 9', 9" des Randstreifens 9 und 10', 10" des Beschichtungsrands 10 befinden.

Ansonsten entspricht die Konfiguration der Stromversorgungsleitungen 16, 16' der Zusatzelektrode 15 und der durchgehenden beschichtungsfreien Linien 21, 21' der Konfiguration der Windschutzscheibe gemäß der Figur 7.

### Figur 12

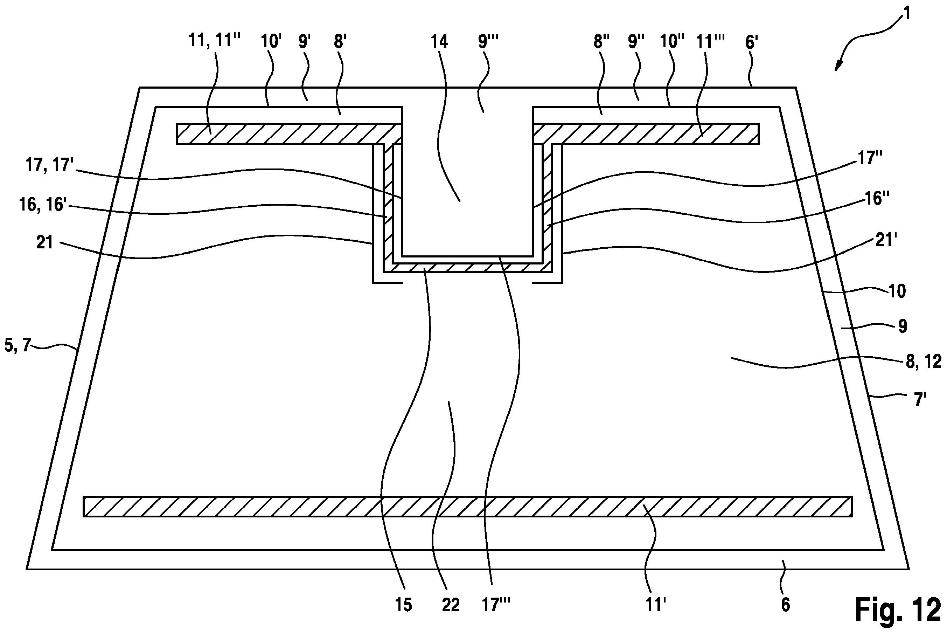

Die Windschutzscheibe 1 der Figur 12 entspricht der Windschutzscheibe 1 gemäß der Figur 11, mit dem wesentlichen Unterschied, dass die Sammelelektrode 11 zwei voneinander räumlich getrennte Teilbereiche 11", 11''' aufweist. Die inneren Enden stoßen an die seitlichen Zonenränder 17', 17" der beschichtungsfreien Zone 14, 9'" an. Die beiden Teilbereiche 11", 11''' werden über die ihnen jeweils zugeordneten Stromversorgungsleitungen 16', 16" und die Zusatzelektrode 15 elektrisch miteinander verbunden.

Ansonsten entspricht die Konfiguration der durchgehenden beschichtungsfreien Linien 21, 21 derjenigen der Windschutzscheibe 1 gemäß Figur 11.

Durch die erfindungsgemäße Anordnung der Stromversorgungsleitungen 16, 16' und der beschichtungsfreien Linien 21, 21' wird auch bei den erfindungsgemäßen Windschutzscheiben 1 gemäß den Figuren 6 bis 12 die Bildung von Hot Spots beim Anlegen einer Speisespannung und bei längerem Betrieb wirksam verhindert.

## Patentansprüche

1. Transparente Scheibe (1) mit mindestens einer beheizbaren, elektrisch leitfähigen Beschichtung (8) für die Verwendung als Einbauteil in Möbeln, Geräten und Gebäuden sowie in Fortbewegungsmitteln, die mit mindestens zwei zum elektrischen Verbinden mit den beiden Polen einer Spannungsquelle vorgesehenen Sammelelektroden (11, 11') so verbunden ist, dass durch Anlegen einer Speisespannung ein Heizstrom über ein zwischen den Sammelelektroden gebildetes Heizfeld (12) fließt, wobei das Heizfeld (12) zumindest eine beschichtungsfreie Zone (14) enthält, welche von einem zumindest abschnittsweise von der elektrisch leitfähigen Beschichtung (8) gebildeten Zonenrand (17) begrenzt wird, wobei sich die mindestens eine Zusatzelektrode (15) längs des im eingebauten Zustand der transparenten Scheibe (1) unteren Zonenrands (17) der mindestens einen beschichtungsfreien Zone (14) erstreckt, wobei
- mindestens eine Sammelelektrode (11, 11') über mindestens zwei Stromversorgungsleitungen (16, 16') mit mindestens einer Zusatzelektrode (15) elektrisch verbunden ist, wobei
- die Stromversorgungsleitungen (16, 16') aus denselben elektrisch leitfähigen Materialien wie die Sammelelektroden (11, 11') bestehen, wobei
mindestens eine der Stromversorgungsleitungen (16, 16') zumindest abschnittsweise im Heizfeld (12) verläuft, wobei
- die mindestens eine Zusatzelektrode (15) mindestens zwei Stromversorgungsleitungen (16, 16') elektrisch miteinander verbindet und/oder
- die mindestens eine Zusatzelektrode (15) in mindestens zwei voneinander getrennte Teilbereiche untergliedert ist, wobei jeder der mindestens zwei Teilbereiche mit jeweils mindestens einer Stromversorgungsleitung (16, 16') elektrisch verbunden ist, und wobei
- im Heizfeld (12) zumindest abschnittsweise längs mindestens einer Stromversorgungsleitung (16, 16') mindestens eine beschichtungsfreie Linie (21, 21')
verläuft, wobei die beschichtungsfreie Linie (21, 21') auf der von der beschichtungsfreien Zone (14) abgewandten Seite der Stromversorgungsleitung (16, 16') verläuft, **gekennzeichnet durch** eine der drei Alternativen (i), (ii) oder (iii), wobei
(i) die beschichtungsfreien Linien (21, 21') von einer Sammelelektrode (11) aus durch das Heizfeld (12) bis zur Höhe der Zusatzelektrode (15) oder der Höhe der Teilbereiche der Zusatzelektrode verlaufen, wobei mindestens eine der beiden Sammelelektroden in mindestens zwei voneinander getrennte Teilbereiche (11", 11‴) untergliedert ist, wobei jeder der mindestens zwei Teilbereiche (11", 11‴) über mindestens eine Stromversorgungsleitung (16, 16') mit der mindestens einen Zusatzelektrode (15) und/oder mit mindestens einem der Teilbereiche der mindestens einen Zusatzelektrode (15) elektrisch verbunden ist,
(ii) die beschichtungsfreien Linien (21, 21') von einer Sammelelektrode (11) aus durch das Heizfeld (12) bis zur Höhe der Zusatzelektrode (15) oder der Höhe der Teilbereiche der Zusatzelektrode (15) und von da aus abschnittsweise durch den Heizfeldabschnitt längs der Zusatzelektrode (15) oder längster Teilbereiche der Zusatzelektrode (15) verlaufen,
(iii) die beschichtungsfreien Linien (21, 21') im Heizfeld (12) in einem gewissen Abstand zu einer Sammelelektrode (11) beginnen.

2. Transparente Scheibe (1) nach Anspruch 1, Alternative (ii) oder Alternative (iii), **dadurch gekennzeichnet, dass**
- mindestens eine der beiden Sammelelektroden in mindestens zwei voneinander getrennte Teilbereiche (11", 11‴) untergliedert ist, wobei
- jeder der mindestens zwei Teilbereiche (11", 11‴) über mindestens eine Stromversorgungsleitung (16, 16') mit der mindestens einen Zusatzelektrode (15) und/oder mit mindestens einem der Teilbereiche der mindestens einen Zusatzelektrode (15) elektrisch verbunden ist.

3. Transparente Scheibe (1) nach einem der Ansprüche 1 bis 2, **dadurch gekennzeichnet, dass** die mindestens eine beschichtungsfreie Linie (21, 21') zumindest abschnittsweise geradlinig, wellenförmig, mäanderförmig, sägezahn-förmig und/oder zickzackförmig verläuft.

4. Transparente Scheibe (1) nach einem der Ansprüche 1 bis 3, **dadurch gekennzeichnet, dass** die mindestens eine beschichtungsfreie Linie (21, 21') zumindest abschnittsweise durchgehend und/oder als unterbrochene Linie diskreter Einschnitte verläuft.

5. Transparente Scheibe (1) nach einem der Ansprüche 1 bis 4, **dadurch gekennzeichnet, dass** die mindestens eine beschichtungsfreie Linie (21, 21') durch Laserapplikation der elektrisch leitfähigen Beschichtung (8) des Heizfelds (12) hergestellt ist.

6. Transparente Scheibe (1) nach einem der Ansprüche 1 bis 5, **dadurch gekennzeichnet, dass** mindestens zwei Stromversorgungsleitungen (16, 16') mit mindestens einer Sammelelektrode (11, 11') und/oder mit mindestens einem der mindestens zwei voneinander getrennten Teilbereiche (11", 11‴) mindestens einer Sammelelektrode (11, 11')
- direkt und/oder
- über eine Kopplungsleitung (16") und/oder
- über ein Koppelungsfeld (12') und mindestens eine Kopplungselektrode (16‴) elektrisch verbunden sind.

7. Transparente Scheibe (1) nach Anspruch 1, Alternative (i), und nach einem der Ansprüche 2 bis 6, **dadurch gekennzeichnet, dass**
- jeder der mindestens zwei Teilbereiche (11", 11‴) mit jeweils einem Flachleiter (18) elektrisch leitend verbunden ist, wobei die mindestens zwei Flachleiter (18) mit einem der beiden Pole einer Spannungsquelle elektrisch leitend verbunden sind, oder
- mindestens zwei Teilbereiche (11", 11‴) über ein gemeinsames Verbindungsteil (20) oder über jeweils ein Verbindungsteil (20, 20') mit einem gemeinsamen Flachleiter (18) elektrisch leitend verbunden sind, wobei der gemeinsame Flachleiter (18) und das gemeinsame Verbindungsteil (20) oder die zwei Verbindungsteile (20, 20') von den mindestens zwei Stromversorgungsleitungen (16, 16') elektrisch isoliert angeordnet sind.

8. Transparente Scheibe (1) nach Anspruch 7, **dadurch gekennzeichnet, dass** mindestens eine der Stromversorgungsleitungen (16, 16') unterhalb mindestens einer elektrisch isolierenden Schicht (19), auf der der Flachleiter (18) und das gemeinsame Verbindungsteil (20) oder die zwei Verbindungsteile (20, 20') aufliegen, angeordnet ist.

9. Transparente Scheibe (1) nach einem der Ansprüche 1 bis 8, **dadurch gekennzeichnet, dass** im eingebauten Zustand der transparenten Scheibe (1)
- die mindestens eine erste beschichtungsfreie Zone (14) und die ihr zugeordnete Zone (9‴) des Randstreifens (9) an der oberen ersten Seite (6') eine einheitliche beschichtungsfreie Zone (14, 9‴) bilden oder
- mindestens eine zweite beschichtungsfreie Zone (14') oberhalb des oberen Zonenrands (17"") der mindestens einen ersten beschichtungsfreien Zone (14) angeordnet ist, wobei
- die mindestens eine zweite beschichtungsfreie Zone (14') von dem von der Beschichtung (8) gebildeten Zonenrand (17^{v}) umgeben ist oder
- die mindestens eine zweite beschichtungsfreie Zone (14') und die ihr zugeordnete Zone (9‴) des Randstreifens (9) an der oberen ersten Seite (6') eine einheitliche beschichtungsfreie Zone (14, 9‴) bilden.

10. Transparente Scheibe (1) nach einem der Ansprüche 1 bis 9, **dadurch gekennzeichnet, dass** im eingebauten Zustand der transparenten Scheibe (1) die mindestens eine Zusatzelektrode (15) und/oder die mindestens zwei Teilbereiche der mindestens einen Zusatzelektrode (15) längs des unteren Zonenrands (17"') der mindestens einen ersten beschichtungsfreien Zone (14) in elektrisch leitendem Kontakt mit dem Heizfeldabschnitt (22) angeordnet ist oder sind.

11. Transparente Scheibe (1) nach einem der Ansprüche 2 bis 10, **dadurch gekennzeichnet, dass** die mindestens eine Stromversorgungsleitung (16, 16') abschnittsweise
- in mindestens einem Teilbereich (8', 8") der elektrisch leitfähigen Beschichtung (8) außerhalb des Heizfelds (12),
- durch mindestens eine Zone (9', 9") des Randstreifens (9) im Bereich mindestens einer Zone (10', 10") des Beschichtungsrands (10),
- unterhalb mindestens einer elektrisch isolierenden Schicht (19), auf der ein Flachleiter (18) und mindestens ein Verbindungsteil (20, 20') zwischen dem Flachleiter (18) und den mindestens zwei Teilbereichen (11", 11‴) aufliegen, angeordnet ist,
- innerhalb des von der elektrisch leitfähigen Beschichtung (8) gebildeten Zonenrands (17^{v}) der mindestens einen zweiten beschichtungsfreien Zone (14') oder (14, 9‴),
- durch das Heizfeld (12) und
- längs mindestens eines seitlichen Zonenrands (17', 17") der mindestens einen ersten beschichtungsfreien Zone (14)
zu der mindestens einen Zusatzelektrode (15) verläuft.

12. Verfahren zur Herstellung einer transparenten Scheibe (1) gemäß einem der Ansprüche 1 bis 11 mit den folgenden Verfahrensschritten:
(A) Herstellen einer elektrisch leitfähigen Beschichtung (8);
(B) Herstellen mindestens einer beschichtungsfreien Zone (14) in der elektrisch leitfähigen Beschichtung (8) und im Heizfeld (12);
(C) Ausbilden von
(c1) mindestens zwei mit den beiden Polen einer Spannungsquelle verbundenen Sammelelektroden (11, 11'), die mit der elektrisch leitfähigen Beschichtung (8) elektrisch verbunden sind, so dass durch Anlegen einer Speisespannung ein Heizstrom über ein zwischen den beiden Sammelelektroden (11, 11') befindliches Heizfeld (12) fließt, und/oder
(c2) mindestens zwei mit den beiden Polen einer Spannungsquelle verbundenen Sammelelektroden (11, 11'), die mit der elektrisch leitfähigen Beschichtung (8) elektrisch verbunden sind, wobei mindestens eine der beiden Sammelelektroden (11, 11") in mindestens zwei voneinander getrennte Teilbereiche (11") und (11‴) untergliedert ausgeführt wird;
(D) Herstellen
(d1) mindestens einer zum elektrischen Verbinden mit mindestens einer der beiden Sammelelektroden (11, 11') vorgesehenen Zusatzelektrode (15) und/oder
(d2) mindestens zweier zum elektrischen Verbinden mit mindestens einer der beiden Sammelelektroden (11, 11') vorgesehenen Teilbereiche der Zusatzelektrode (15) und/oder
(d3) mindestens einer zum elektrischen Verbinden mit mindestens zwei voneinander getrennten Teilbereichen (11", 11‴) vorgesehenen Zusatzelektrode (15) und/oder
(d4) mindestens zweier zum elektrischen Verbinden mit jeweils mindestens einem der mindestens zwei voneinander getrennten Teilbereiche (11", 11‴) vorgesehenen Teilbereiche der Zusatzelektrode (15);
(E) Herstellen mindestens zweier Stromversorgungsleitungen (16, 16') für die mindestens eine Zusatzelektrode (15) oder ihre mindestens zwei Teilbereiche,
(e1) die von mindestens einer der beiden Sammelelektroden (11, 11') zu der mindestens einen Zusatzelektrode (15) geführt werden,
(e2) von denen jeweils mindestens eine von jedem der mindestens zwei Teilbereiche (11", 11‴) zu der mindestens einen Zusatzelektrode (15) geführt wird,
(e3) von denen jeweils mindestens eine von mindestens einer der beiden Sammelelektroden (11, 11') zu jedem der mindestens zwei Teilbereiche der Zusatzelektrode (15) geführt wird,
(e4) von denen jeweils mindestens eine von jedem der mindestens zwei Teilbereiche (11", 11‴) zu jedem der mindestens zwei Teilbereiche der Zusatzelektrode (15) geführt wird,
(e5) die beide mit einer Kopplungsleitung (16") verbunden werden, die zu mindestens einer der beiden Sammelelektroden (11, 11') oder zu einem der mindestens zwei Teilbereiche (11", 11‴) geführt wird, oder
(e6) die beide mit einer Kopplungselektrode (16‴) verbunden werden, die über ein zwischen der Kopplungselektrode (16‴) einerseits und mindestens einer Sammelelektrode (11, 11') oder mindestens einem Teilbereich (11", 11‴) andererseits im Heizfeld (12) befindliches Koppelungsfeld (12') mit der mindestens einen Sammelelektrode (11, 11') oder mindestens einem Teilbereich (11", 11‴ ) elektrisch verbunden wird; und
(F) Herstellen mindestens einer beschichtungsfreien Linie (21, 21') im Heizfeld (12) längs der der beschichtungsfreien Zone (14) abgewandten Seite zumindest eines Abschnitts mindestens einer Stromversorgungsleitung (16, 16') vor, während oder nach dem Verfahrensschritt (B), wobei
(G) die Verfahrensschritte (C), (D) und (E) nacheinander oder gleichzeitig durchgeführt werden.

13. Verfahren nach Anspruch 12, **dadurch gekennzeichnet, dass**
- das die mindestens eine beschichtungsfreie Linie (21, 21') im Verfahrensschritt (F) durch Laserablation der elektrisch leitfähigen Beschichtung (8) des Heizfelds (12) hergestellt wird und
- die Verfahrensschritte (C), (D) und (E) mithilfe des Siebdrucks durchgeführt werden.

## Claims

1. Transparent pane (1) having at least one heatable, electrically conductive coating (8) for the use as a built-in component in furniture, devices and buildings, as well as means of transportation, which is connected to at least two collecting electrodes (11, 11') provided for the electrical connection to the two terminals of a voltage source such that, by applying a supply voltage, a heating current flows via a heating field (12) formed between the collecting electrodes, wherein the heating field (12) contains at least one coating-free zone (14), which is bordered by a zone edge (17) formed at least in sections by the electrically conductive coating (8), wherein the at least one additional electrode (15) extends along the lower zone edge (17) of the at least one coating-free zone (14), in the installed state of the transparent pane (1), wherein
- at least one collecting electrode (11, 11') is electrically connected via at least two electrical supply lines (16, 16') to at least one additional electrode (15), wherein
- the electrical supply lines (16, 16') are made of the same electrically conductive materials as the collecting electrodes (11, 11'), wherein at least one of the electrical supply lines (16, 16') runs at least in sections in the heating field (12), wherein
- the at least one additional electrode (15) electrically connects at least two electrical supply lines (16, 16') to one another, and/or
- the at least one additional electrode (15) is subdivided into at least two subregions separated from one another, wherein each of the at least two subregions is electrically connected in each case to at least one electrical supply line (16, 16'), and wherein
- in the heating field (12) at least one coating-free line (21, 21') runs along at least one electrical supply line (16, 16') at least in sections, wherein the coating-free line (21, 21') runs along the side of the electrical supply line (16, 16') facing away from the coating-free zone (14),
**characterized by** one of the alternatives (i), (ii) or (iii), wherein
(i) the coating-free lines (21, 21') run out from one collecting electrode (11) through the heating field (12) all the way to the level of the additional electrode (15) or all the way to the level of the subregions of the additional electrode, wherein at least one of the two collecting electrodes is subdivided into at least two subregions (11", 11‴) separated from one another, wherein each of the at least two subregions (11", 11‴) is electrically connected via at least one electrical supply line (16, 16') to the at least one additional electrode (15) and/or to at least one of the subregions of the at least one additional electrode (15),
(ii) the coating-free lines (21, 21') run out from a collecting electrode (11) through the heating field (12) all the way to the level of the additional electrode (15) or to the level of the subregions of the additional electrode (15) and from there out in sections through the heating field section along the additional electrode (15) or longest subregions of the additional electrode (15),
(iii) the coating-free lines (21, 21') begin in the heating field (12) at a certain distance from the collecting electrode (11).

2. Transparent pane (1) according to claim 1, alternative (ii) or alternative (iii), **characterized in that**
- at least one of the two collecting electrodes is subdivided into at least two subregions (11", 11‴) separated from one another, wherein
- each of the at least two subregions (11", 11‴) is electrically connected via at least one electrical supply line (16, 16') to the at least one additional electrode (15) and/or to at least one of the subregions of the at least one additional electrode (15).

3. Transparent pane (1) according to one of claims 1 through 2, **characterized in that** the at least one coating-free line (21, 21') runs at least in sections in a straight line, in the shape of a wave, a meander, saw teeth, and/or a zigzag.

4. Transparent pane (1) according to one of claims 1 through 3, **characterized in that** the at least one coating-free line (21, 21') runs at least in sections continuously and/or as a broken line with discrete breaks.

5. Transparent pane (1) according to one of claims 1 through 4, **characterized in that** the at least one coating-free line (21, 21') is produced by laser application of the electrically conductive coating (8) of the heating field (12).

6. Transparent pane (1) according to one of claims 1 through 5, **characterized in that** at least two electrical supply lines (16, 16') are electrically connected to at least one collecting electrode (11, 11') and/or to at least one of the at least two subregions (11", 11‴) of at least one collecting electrode (11, 11') separated from one another
- directly and/or
- via a coupling line (16") and/or
- via a coupling field (12') and at least one coupling electrode (16‴).

7. Transparent pane (1) according to claim 1, alternative (i), and according to one of claims 2 through 6, **characterized in that**
- each of the at least two subregions (11", 11‴) is electrically conductively connected in each case to one flat conductor (18), wherein the at least two flat conductors (18) are electrically conductively connected to one of the two terminals of a voltage source, or
- at least two subregions (11", 11‴) are electrically conductively connected to a common flat conductor (18) via a common connecting part (20) or via one connecting part (20, 20') in each case, wherein the common flat conductor (18) and the common connecting part (20) or the two connecting parts (20, 20') are arranged electrically isolated from the at least two electrical supply lines (16, 16').

8. Transparent pane (1) according to claim 7, **characterized in that** at least one of the electrical supply lines (16, 16') is arranged below at least one electrically insulating layer (19), on which the flat conductor (18) and the common connecting part (20) or the two connecting parts (20, 20') lie.

9. Transparent pane (1) according to one of claims 1 through 8, **characterized in that** in the installed state of the transparent pane (1)
- the at least one first coating-free zone (14) and the zone (9"') of the edge strip (9) associated therewith form a unified coating-free zone (14, 9"') on the upper first side (6'), or
- at least one second coating-free zone (14') is arranged above the upper zone edge (17ʺʺ) of the at least one first coating-free zone (14), wherein
- the at least one second coating-free zone (14') is surrounded by the zone edge (17^{v}) formed by the coating (8), or
- the at least one second coating-free zone (14') and the zone (9‴) of the edge strip (9) associated therewith form a unified coating-free zone (14, 9"') on the upper first side (6').

10. Transparent pane (1) according to one of claims 1 through 9, **characterized in that** in the installed state of the transparent pane (1) the at least one additional electrode (15) and/or the at least two subregions of the at least one additional electrode (15) is/are arranged along the lower zone edge (17"') of the at least one first coating-free zone (14) in electrically conductive contact with the heating field section (22).

11. Transparent pane (1) according to one of claims 2 through 10, **characterized in that** the at least one electrical supply line (16, 16') runs in sections
- in at least one subregion (8', 8") of the electrically conductive coating (8) outside the heating field (12),
- through at least one zone (9', 9") of the edge strip (9) in the region of at least one zone (10', 10") of the coating edge (10),
- below at least one electrically insulating layer (19), on which a flat conductor (18) and at least one connecting part (20, 20') are arranged between the flat conductor (18) and the at least two subregions (11", 11‴),
- inside the zone edge (17^{v}) of the at least one second coating-free zone (14') or (14, 9‴) formed by the electrically conductive coating (8),
- through the heating field (12), and
- along at least one lateral zone edge (17', 17") of the at least one first coating-free zone (14)
to the at least one additional electrode (15).

12. Method for producing a transparent pane (1) according to one of claims 1 through 11 with the following process steps:
(A) Producing an electrically conductive coating (8);
(B) Producing at least one coating-free zone (14) in the electrically conductive coating (8) and in the heating field (12);
(C) Forming
(c1) at least two collecting electrodes (11, 11') connected to the two terminals of a voltage source, which are electrically connected to the electrically conductive coating (8), such that by applying a supply voltage a heating current flows via a heating field (12) situated between the two collecting electrodes (11, 11'), and/or
(c2) at least two collecting electrodes (11, 11') connected to the two terminals of a voltage source, which are electrically connected to the electrically conductive coating (8), wherein at least one of the two collecting electrodes (11, 11") is implemented subdivided into at least two subregions (11") and (11‴) separated from one another;
(D) Producing
(d1) at least one additional electrode (15) provided for electrically connecting to at least one of the two collecting electrodes (11, 11') and/or
(d2) at least two subregions of the additional electrode (15) provided for electrically connecting to at least one of the two collecting electrodes (11, 11') and/or
(d3) at least one additional electrode (15) provided for electrically connecting to at least two subregions (11", 11‴) separated from one another and/or
(d4) at least two subregions of the additional electrode (15) provided for electrically connecting to, in each case, at least one of the at least two subregions (11", 11‴) separated from one another;
(E) Producing at least two electrical supply lines (16, 16') for the at least one additional electrode (15) or its at least two subregions,
(e1) which are guided from at least one of the two collecting electrodes (11, 11') to the at least one additional electrode (15),
(e2) of which, in each case, at least one of each of the at least two subregions (11", 11‴) is guided to the at least one additional electrode (15),
(e3) of which, in each case, at least one of at least one of the two collecting electrodes (11, 11') is guided to each of the at least two subregions of the additional electrode (15),
(e4) of which, in each case, at least one of each of the at least two subregions (11", 11‴) is guided to each of the at least two subregions of the additional electrode (15),
(e5) which are both connected to a coupling line (16"), which is guided to at least one of the two collecting electrodes (11, 11') or to one of the at least two subregions (11", 11‴), or
(e6) which are both connected to a coupling electrode (16‴), which is electrically connected via a coupling field (12') situated in the heating field (12) between the coupling electrode (16"') on the one hand and at least one collecting electrode (11, 11') or at least one subregion (11", 11‴) on the other to the at least one collecting electrode (11, 11') or at least one subregion (11", 11‴); and
(F) Producing at least one coating-free line (21, 21') in the heating field (12) along the side of at least one section of at least one electrical supply line (16, 16') facing away from the coating-free zone (14) before, during, or after process step (B), wherein
(G) the process steps (C), (D), and (E) are performed in succession or simultaneously.

13. Method according to claim 12, **characterized in that**
- the at least one coating-free line (21, 21') is produced in process step (F) by laser ablation of the electrically conductive coating (8) of the heating field (12), and
- the process steps (C), (D) and (E) are performed using screen printing.

## Revendications

1. Vitre transparente (1) avec au moins un revêtement électriquement conducteur pouvant être chauffé et (8) pour la utilisation comme élément pour installation dans les meubles, les appareils et les bâtiments et les moyens de transport, qui est relié à au moins deux électrodes collectrices (11, 11') prévues pour la connexion électrique aux deux pôles d'une source de tension de telle manière que, par l'application d'une tension d'alimentation, un courant de chauffage circule par un champ de chauffage (12) formé entre les électrodes collectrices, où le champ de chauffage (12) contient au moins une zone sans revêtement (14) qui est délimité par une bordure (17) qui est formé au moins par sections, par le revêtement (14) électriquement conducteur (8), où l'au moins une électrode supplémentaire (15) s'étendant le long de las bordure inférieur (17) de l'au moins une zone sans revêtement (14) à l'état monté de la vitre transparente (1),
- au moins une électrode collectrice (11, 11') est reliée électriquement à au moins une électrode supplémentaire (15) par au moins deux lignes d'alimentation (16, 16'), où
- les lignes d'alimentation électrique (16, 16') sont constituées des mêmes matériaux électriquement conducteurs que les électrodes collectrices (11, 11'), où au moins une des lignes d'alimentation électrique (16, 16') s'étend au moins par sections dans le champ de chauffage (12), où
- ladite au moins une électrode supplémentaire (15) relie électriquement au moins deux lignes d'alimentation (16, 16') entre elles et/ou
- ladite au moins une électrode supplémentaire (15) est subdivisée en au moins deux zones partielles séparées l'une de l'autre, où chacune des au moins deux zones partielles est reliée électriquement à au moins une ligne d'alimentation électrique (16, 16') respectivement, et où
- au moins une ligne sans revêtement (21, 21') s'étend dans le champ de chauffage (12) au moins par sections le long d'au moins une ligne d'alimentation (16, 16'), où la ligne sans revêtement (21, 21') s'étend sur le côté de la ligne d'alimentation (16, 16') éloigné de la zone sans revêtement (14),
**caractérisée par** l'une des trois alternatives (i), (ii) ou (iii), où
(i) les lignes sans revêtement (21, 21') s'étendent d'une électrode collectrice (11) à travers le champ de chauffage (12) jusqu'à la hauteur de l'électrode supplémentaire (15) ou la hauteur des zones partielles de l'électrode supplémentaire, où au moins une des deux électrodes collectrices est subdivisée en au moins deux zones partielles (11", 11‴) séparées l'une de l'autre, où chacune des au moins deux zones partielles (11", 11‴) est reliée électriquement par l'intermédiaire d'au moins une ligne d'alimentation (16, 16') à ladite au moins une électrode supplémentaire (15) et/ou à au moins une des zones partielles de ladite au moins une électrode supplémentaire (15),
(ii) les lignes sans revêtement (21, 21') s'étendent d'une électrode collectrice (11) à travers le champ de chauffage (12) jusqu'à la hauteur de l'électrode supplémentaire (15) ou la hauteur des zones partielles de l'électrode supplémentaire (15) et de là par sections à travers la section du champ de chauffage le long de l'électrode supplémentaire (15) ou des zones partielles les plus longues de l'électrode supplémentaire (15),
(iii) les lignes sans revêtement (21, 21') commencent dans le champ de chauffage (12) à une certaine distance d'une électrode collectrice (11).

2. Vitre transparente (1) selon la revendication 1, alternative (ii) ou alternative (iii), **caractérisée en ce que**
- au moins une des deux électrodes collectrices est subdivisée en au moins deux zones partielles (11", 11‴) séparées l'une de l'autre, où
- chacune des au moins deux zones partielles (11", 11‴) est reliée électriquement par l'intermédiaire d'au moins une ligne d'alimentation (16, 16') à ladite au moins une électrode supplémentaire (15) et/ou à au moins une des zones partielles de ladite au moins une électrode supplémentaire (15).

3. Vitre transparente (1) selon l'une des revendications 1 à 2, **caractérisée en ce que** ladite au moins une ligne sans revêtement (21, 21') s'étend au moins par sections en ligne droite, en ondulations, en méandres, en dents de scie et/ou en zigzag.

4. Vitre transparente (1) selon l'une des revendications 1 à 3, **caractérisée en ce que** ladite au moins une ligne sans revêtement (21, 21') s'étend au moins par sections à travers et/ou sous la forme d'une ligne discontinue d'entailles discrètes.

5. Vitre transparente (1) selon l'une des revendications 1 à 4, **caractérisée en ce que** ladite au moins une ligne sans revêtement (21, 21') est produite par l'application au laser du revêtement électriquement conducteur (8) du champ de chauffage (12).

6. Vitre transparente (1) selon l'une des revendications 1 à 5, **caractérisée en ce qu'**au moins deux lignes d'alimentation (16, 16') sont pourvues d'au moins une électrode collectrice (11, 11') et/ou d'au moins l'une des au moins deux zones partielles (11", 11‴) d'au moins une électrode collectrice (11, 11') séparées entre elles sont reliés électriquement
- directement et/ou
- par une ligne d'accouplement (16") et/ou
- par un champ de couplage (12') et au moins une électrode de couplage (16‴).

7. Vitre transparente (1) selon la revendication 1, alternative (i), et selon l'une quelconque des revendications 2 à 6, **caractérisée en ce que**
- chacune des au moins deux zones partielles (11", 11‴) est reliée électriquement respectivement à un conducteur plat (18), où les au moins deux conducteurs plats (18) étant reliés électriquement à un des deux pôles d'une source de tension,
- au moins deux zones partielles (11", 11‴) sont reliées électriquement de manière conductrice à un conducteur plat commun (18) par une pièce de raccordement commune (20) ou par une pièce de raccordement respective (20, 20'), où le conducteur plat commun (18) et la pièce de raccordement commune (20) ou les deux pièces de raccordement (20, 20') sont disposés de manière électriquement isolée des au moins deux lignes d'alimentation électrique (16, 16').

8. Vitre transparente (1) selon la revendication 7, **caractérisée en ce qu'**au moins l'une des lignes d'alimentation (16, 16') est disposée sous au moins une couche électriquement isolante (19) sur laquelle reposent le conducteur plat (18) et la pièce de raccordement commune (20) ou les deux pièces de raccordement (20, 20').

9. Vitre transparente (1) selon l'une des revendications 1 à 8, **caractérisée en ce que**, à l'état monté de la vitre transparente (1)
- ladite au moins une première zone sans revêtement (14) et la zone associée (9‴) de la bande latérale (9) forment sur la première face supérieure (6') une zone uniforme sans revêtement (14, 9"), ou
- au moins une deuxième zone sans revêtement (14') est disposée au-dessus du bord supérieur (17"") de ladite au moins une première zone sans revêtement (14), où
- ladite au moins une deuxième zone sans revêtement (14') est entourée par la bordure (17") formée par le revêtement (8), ou
- ladite au moins une deuxième zone sans revêtement (14') et la zone associée (9‴) de la bande latérale (9) forment une zone sans revêtement uniforme (14, 9") sur la première face supérieure (6').

10. Vitre transparente (1) selon l'une des revendications 1 à 9, **caractérisée en ce que**, à l'état monté de la vitre transparente (1), ladite au moins une électrode supplémentaire (15) et/ou lesdites au moins deux zones partielles de ladite au moins une électrode supplémentaire (15) est disposée ou sont disposées le long du bord inférieur (17‴) de ladite au moins une première zone sans revêtement (14) en contact électriquement conducteur avec la pièce chauffante (22)

11. Vitre transparente (1) selon l'une des revendications 2 à 10, **caractérisée en ce que** ladite au moins une ligne d'alimentation (16, 16') est disposée par sections
- dans au moins une zone partielle (8', 8") du revêtement électriquement conducteur (8) en dehors du champ de chauffage (12),
- par au moins une zone (9', 9") de la bande latérale (9) dans la zone d'au moins une zone (10', 10") du bord de revêtement (10),
- est disposée sous au moins une couche électriquement isolante (19), sur laquelle reposent un conducteur plat (18) et au moins une pièce de raccordement (20, 20') entre le conducteur plat (18) et lesdites au moins deux zones partielles (11", 11‴),
- à l'intérieur du bord de zone (17") de ladite au moins une deuxième zone sans revêtement (14') ou (14, 9") formée par le revêtement électriquement conducteur (8),
- à travers le champ de chauffage (12) et
- s'étend le long d'au moins un bord de zone (17', 17") latéral de ladite au moins une première zone sans revêtement (14) jusqu'à ladite au moins une électrode supplémentaire (15).

12. Procédé de fabrication d'une vitre transparente (1) selon l'une des revendications 1 à 11, avec les étapes de procédé suivantes :
(A) fabrication d'un revêtement électriquement conducteur (8) ;
(B) fabrication d'au moins une zone sans revêtement (14) dans le revêtement électriquement conducteur (8) et dans le champ de chauffage (12) ;
(C) formation de
(c1) au moins deux électrodes collectrices (11, 11') qui sont reliées aux deux pôles d'une source de tension et qui sont reliées électriquement au revêtement électriquement conducteur (8), de telle manière que lors de l'application d'une tension d'alimentation, un courant de chauffage circule par une zone chauffante (12) qui est situé entre les deux électrodes collectrices (11, 11'), et/ou (02) au moins deux électrodes collectrices (11, 11') qui sont reliées aux deux pôles d'une source de tension, qui sont reliées électriquement au revêtement électriquement conducteur (8), où au moins l'une des deux électrodes collectrices (11, 11') est subdivisée en au moins deux zones partielles (11") et (11‴) qui sont séparées l'une de l'autre ;
(D) Fabrication
(d1) au moins une électrode supplémentaire (15) prévue pour le raccordement électrique à au moins l'une des deux électrodes collectrices (11, 11') et/ou
(d2) au moins deux zones partielles de l'électrode supplémentaire (15) prévues pour le raccordement électrique à au moins l'une des deux électrodes collectrices (11, 11'), et/ou
(d3) au moins une électrode supplémentaire (15) prévue pour le raccordement électrique à au moins deux zones partielles (11", 11‴) séparées l'une de l'autre, et/ou
(d4) au moins deux zones partielles de l'électrode supplémentaire (15) pour le raccordement électrique à au moins l'une des deux zones partielles (11", 11‴) de l'électrode supplémentaire (15) qui sont séparées l'une de l'autre ;
(E) fabrication d'au moins deux lignes d'alimentation électrique (16, 16") pour ladite au moins une électrode supplémentaire (15) ou ses au moins deux zones partielles,
(e1) qui sont conduits d'au moins une des deux électrodes collectrices (11, 11') vers ladite au moins une électrode supplémentaire (15),
(e2) dont respectivement au moins une des au moins deux zones partielles (11, 11‴) est conduite vers ladite au moins une électrode supplémentaire (15),
(e3) dont respectivement au moins une d'au moins une des deux électrodes collectrices (11, 11') est conduite vers chacune des deux zones partielles de l'électrode supplémentaire (15),
(e4) dont respectivement au moins une de chacune des au moins deux zones partielles (11", 11‴) est conduite vers chacune des au moins deux zones partielles de l'électrode supplémentaire (15),
(e5) qui sont toutes les deux reliées à un câble de couplage (16") qui est conduit vers au moins l'une des deux électrodes collectrices (11, 11') ou vers l'une des au moins deux zones partielles (11", 11‴), ou
(e6) qui sont toutes les deux reliées à une électrode de couplage (16‴) qui est reliée électriquement par l'intermédiaire d'un champ de couplage (12') situé dans le champ de chauffage (12) entre l'électrode de couplage (16‴) d'une part, et au moins une électrode collectrice (11, 11') ou au moins une zone partielle (11", 11‴), d'autre part à ladite au moins une électrode de couplage (16‴) ou ladite au moins une zone partielle (11", 11‴) ; et
(F) fabrication d'au moins une ligne sans revêtement (21, 21') dans le champ de chauffage (12) le long du côté opposé à la zone sans revêtement (14) d'au moins une section d'au moins une ligne d'alimentation électrique (16, 16') avant, pendant ou après l'étape de procédé (B), où
(G) les étapes de procédé (C), (D) et (E) sont réalisées successivement ou simultanément.

13. Procédé selon la revendication 12, **caractérisé en ce que**
- ladite au moins une ligne sans revêtement (21, 21') est produite dans l'étape de procédé (F) par ablation au laser du revêtement électriquement conducteur (8) du champ de chauffage (12), et
- les étapes de procédé (C), (D) et (E) sont réalisées par sérigraphie.
